# EUROPEAN PATENT APPLICATION

(11) **EP 4 617 746 A1**
(43) Date of publication of application: **17.09.2025**
(21) Application number: 25162545.5
(22) Date of filing: 10.03.2025
(51) Int. Cl.: G02B 6/42, G02B 6/43

(54) **SYSTEM AND METHODS FOR CO-PACKAGE OPTICS PACKAGE ARCHITECTURE**

(30) Priority: 11.03.2024 US 202463563946 P; 03.02.2025 US 202519044617
(71) Applicant: Samsung Electronics Co., Ltd., Suwon-si, Gyeonggi-do 16677 (KR)
(72) Inventor: LI, Yan, San Jose, CA, 95134, (US); YANG, Jin, San Jose, CA, 95134 (US); KIM, WooPoung, San Jose, CA, 95134 (US)
(74) Representative: Kuhnen & Wacker Patent- und Rechtsanwaltsbüro PartG mbB

(57) **Abstract**

Systems, methods and devices disclosed herein may include supportive interchange, a first compute device and a second compute device positioned on the supportive interchange, and a photonic integrated circuit positioned between the first compute device and the second compute device. The photonic integrated circuit may communicatively couple the first compute device and the second compute device. An optical fiber connection may couple to the photonic integrated circuit between the first compute device and the second compute device.

## Description

### TECHNICAL FIELD

The subject matter disclosed herein relates to packaging. More particularly, the subject matter disclosed herein relates to a technique for connecting with electronic integrated circuits (EICs) and photonic integrated circuits (PICs).

### BACKGROUND

Semiconductor devices may connect to additional devices and circuitry on different substrates. Forming connections between substrates may provide increased computational power. However, forming connections between substrates may cause difficulties. Packaging describes the general method for connecting and integrating multiple computational components together in an integrated unit, and may involve multiple different types of integrated circuits on multiple substrates which may combine into a single unit. Packaging may also describe a method for which multiple computational components within a single unit are protected by the use of various techniques to provide thermal, physical and electrical protection It is noted that the background concepts discussed herein are for informational purposes only and are not intended to limit the present disclosure. Nor should the background or field described herein be intended to limit the disclosure herein to a particular use or concept.

### SUMMARY

A device disclosed herein may include a supportive interchange, a first compute device and a second compute device positioned on the supportive interchange, and a photonic integrated circuit positioned between the first compute device and the second compute device. The photonic integrated circuit may communicatively couple the first compute device and the second compute device. An optical fiber connection may couple to the photonic integrated circuit between the first compute device and the second compute device. The first compute device may include at least one of a memory device and a processing device. A redistribution layer may be arranged between the photonic integrated circuit and the first compute device, as well as the photonic integrated circuit and the second compute device. The redistribution layer may communicatively couple the photonic integrated circuit and the first compute device and the photonic integrated circuit and the second compute device. The photonic integrated circuit may be at least partially embedded within the supportive interchange. The photonic integrated circuit may be positioned on the supportive interchange. The photonic integrated circuit may include a first photonic integrated circuit and a second photonic integrated circuit, with the optical fiber connection including a first optical fiber connection coupled to the first photonic integrated circuit and a second optical fiber connection coupled to the second photonic integrated circuit. The supportive interchange may have the first compute device, the second compute device and the photonic integrated circuit positioned on a first side of the supportive interchange. An encapsulation layer may extend between the first compute device, the second compute device, and the optical fiber connection.

An example embodiment of a system may include a substrate having a first side and a second side opposite the first side. A first compute device and a second compute device may be positioned on the first side. A photonic integrated circuit may be arranged between the first compute device and the second compute device, the photonic integrated circuit communicatively coupled to the first compute device and the second compute device. An optical fiber connection may extend between the first compute device and the second compute device. The photonic integrated circuit may be at least partially embedded within the substrate. The photonic integrated circuit may be positioned on the first side of the substrate with the first compute device positioned at least partially over the photonic integrated circuit. The first compute device and the second compute device may include at least one of a memory device and a processing device. The first compute device and the second compute device may differ in their device composition. The first compute device and the second compute device may have the same device composition. A redistribution layer may be arranged between the photonic integrated circuit and the first compute device, and maybe arranged between the photonic integrated circuit and the second compute device, with the redistribution layer communicatively coupling the photonic integrated circuit to the first compute device and the photonic integrated circuit with the second compute device.

In an example embodiment of a method, a substrate is prepared, with a redistribution layer formed on a first side of the substrate, a photonic integrated circuit is coupled to the redistribution layer, an open area may be formed over the redistribution layer, a first compute device may be positioned on the redistribution layer and electrically connect to the photonic integrated circuit. A second compute device may be positioned on the redistribution layer and electrically connect to the photonic integrated circuit. An optical fiber connection may be connected via the open area to the photonic integrated circuit and between the first compute device and the second compute device. The photonic integrated circuit may be coupled to the redistribution layer by positioning the photonic integrated circuit on the redistribution layer. The optical fiber may connect to a surface of the photonic integrated circuit parallel to the first side of the substrate. The first compute device may include a first device and a second device, which include at least one of a processing device and a memory device. The open area formed over the photonic integrated circuit may be formed by removing a portion of the redistribution layer formed over the photonic integrated circuit.

### BRIEF DESCRIPTION OF THE DRAWING

In the following section, the aspects of the subject matter disclosed herein will be described with reference to exemplary embodiments illustrated in the figures, in which:
FIG. 1 depicts a cross-section view of a hybrid electronic integrated circuit and photonic integrated circuit system according to various embodiments of the subject matter disclosed herein;
FIG. 2 depicts a plan view of a hybrid electronic integrated circuit and photonic integrated circuit system according to various embodiments of the subject matter disclosed herein;
FIG. 3 depicts a cross-section view of a hybrid electronic integrated circuit and photonic integrated circuit system according to various embodiments of the subject matter disclosed herein;
FIG. 4 depicts a plan view of a hybrid electronic integrated circuit and photonic integrated circuit system according to various embodiments of the subject matter disclosed herein; and
FIG. 5A depicts a cross-section view of an example embodiment of a hybrid electronic integrated circuit and photonic integrated circuit system at a first stage of manufacturing;
FIG. 5B depicts a cross-section view of an example embodiment of a hybrid electronic integrated circuit and photonic integrated circuit system at a second stage of manufacturing;
FIG. 5C depicts a cross-section view of an example embodiment of a hybrid electronic integrated circuit and photonic integrated circuit system at a third stage of manufacturing;
FIG. 5D depicts a cross-section view of an example embodiment of a hybrid electronic integrated circuit and photonic integrated circuit system at a fourth stage of manufacturing;
FIG. 5E depicts a cross-section view of an example embodiment of a hybrid electronic integrated circuit and photonic integrated circuit system at a fifth stage of manufacturing;
FIG. 5F depicts a cross-section view of an example embodiment of a hybrid electronic integrated circuit and photonic integrated circuit system at a sixth stage of manufacturing;
FIG. 5G depicts a cross-section view of an example embodiment of a hybrid electronic integrated circuit and photonic integrated circuit system at a seventh stage of manufacturing;
FIG. 5H depicts a cross-section view of an example embodiment of a hybrid electronic integrated circuit and photonic integrated circuit system at an eighth stage of manufacturing;
FIG. 5I depicts a cross-section view of an example embodiment of a hybrid electronic integrated circuit and photonic integrated circuit system at a ninth stage of manufacturing;
FIG. 5J depicts a cross-section view of an example embodiment of a hybrid electronic integrated circuit and photonic integrated circuit system at a tenth stage of manufacturing;
FIG. 5K depicts a cross-section view of an example embodiment of a hybrid electronic integrated circuit and photonic integrated circuit system at an eleventh stage of manufacturing;
FIG. 5L depicts a cross-section view of an example embodiment of a hybrid electronic integrated circuit and photonic integrated circuit system at a twelfth stage of manufacturing;
FIG. 6 depicts a flow chart of a method according to various embodiments of the subject matter disclosed herein;
FIG. 7A depicts a cross-section view of an example embodiment of a hybrid electronic integrated circuit and photonic integrated circuit system at a first stage of manufacturing;
FIG. 7B depicts a cross-section view of an example embodiment of a hybrid electronic integrated circuit and photonic integrated circuit system at a second stage of manufacturing;
FIG. 7C depicts a cross-section view of an example embodiment of a hybrid electronic integrated circuit and photonic integrated circuit system at a third stage of manufacturing;
FIG. 7D depicts a cross-section view of an example embodiment of a hybrid electronic integrated circuit and photonic integrated circuit system at a fourth stage of manufacturing;
FIG. 7E depicts a cross-section view of an example embodiment of a hybrid electronic integrated circuit and photonic integrated circuit system at a fifth stage of manufacturing;
FIG. 7F depicts a cross-section view of an example embodiment of a hybrid electronic integrated circuit and photonic integrated circuit system at a sixth stage of manufacturing;
FIG. 7G depicts a cross-section view of an example embodiment of a hybrid electronic integrated circuit and photonic integrated circuit system at a seventh stage of manufacturing;
FIG. 7H depicts a cross-section view of an example embodiment of a hybrid electronic integrated circuit and photonic integrated circuit system at an eighth stage of manufacturing;
FIG. 7I depicts a cross-section view of an example embodiment of a hybrid electronic integrated circuit and photonic integrated circuit system at a ninth stage of manufacturing;
FIG. 7J depicts a cross-section view of an example embodiment of a hybrid electronic integrated circuit and photonic integrated circuit system at a tenth stage of manufacturing;
FIG. 7K depicts a cross-section view of an example embodiment of a hybrid electronic integrated circuit and photonic integrated circuit system at an eleventh stage of manufacturing;
FIG. 7L depicts a cross-section view of an example embodiment of a hybrid electronic integrated circuit and photonic integrated circuit system at a twelfth stage of manufacturing;
FIG. 7M depicts a cross-section view of an example embodiment of a hybrid electronic integrated circuit and photonic integrated circuit system at a thirteenth stage of manufacturing;
FIG. 8 depicts a flow chart of a method according to various embodiments of the subject matter disclosed herein;
FIG. 9A depicts a cross-section view of an example embodiment of a hybrid electronic integrated circuit and photonic integrated circuit system at a first stage of manufacturing;
FIG. 9B depicts a cross-section view of an example embodiment of a hybrid electronic integrated circuit and photonic integrated circuit system at a second stage of manufacturing;
FIG. 9C depicts a cross-section view of an example embodiment of a hybrid electronic integrated circuit and photonic integrated circuit system at a third stage of manufacturing;
FIG. 9D depicts a cross-section view of an example embodiment of a hybrid electronic integrated circuit and photonic integrated circuit system at a fourth stage of manufacturing;
FIG. 9E depicts a cross-section view of an example embodiment of a hybrid electronic integrated circuit and photonic integrated circuit system at a fifth stage of manufacturing;
FIG. 9F depicts a cross-section view of an example embodiment of a hybrid electronic integrated circuit and photonic integrated circuit system at a sixth stage of manufacturing;
FIG. 9G depicts a cross-section view of an example embodiment of a hybrid electronic integrated circuit and photonic integrated circuit system at a seventh stage of manufacturing;
FIG. 9H depicts a cross-section view of an example embodiment of a hybrid electronic integrated circuit and photonic integrated circuit system at an eighth stage of manufacturing;
FIG. 10 depicts a flow chart of a method according to various embodiments of the subject matter disclosed herein;
FIG. 11A depicts a cross-section view of an example embodiment of a hybrid electronic integrated circuit and photonic integrated circuit system at a first stage of manufacturing;
FIG. 11B depicts a cross-section view of an example embodiment of a hybrid electronic integrated circuit and photonic integrated circuit system at a second stage of manufacturing;
FIG. 11C depicts a cross-section view of an example embodiment of a hybrid electronic integrated circuit and photonic integrated circuit system at a third stage of manufacturing;
FIG. 11D depicts a cross-section view of an example embodiment of a hybrid electronic integrated circuit and photonic integrated circuit system at a fourth stage of manufacturing;
FIG. 11E depicts a cross-section view of an example embodiment of a hybrid electronic integrated circuit and photonic integrated circuit system at a fifth stage of manufacturing;
FIG. 11F depicts a cross-section view of an example embodiment of a hybrid electronic integrated circuit and photonic integrated circuit system at a sixth stage of manufacturing;
FIG. 11G depicts a cross-section view of an example embodiment of a hybrid electronic integrated circuit and photonic integrated circuit system at a seventh stage of manufacturing;
FIG. 11H depicts a cross-section view of an example embodiment of a hybrid electronic integrated circuit and photonic integrated circuit system at an eighth stage of manufacturing;
FIG. 11I depicts a cross-section view of an example embodiment of a hybrid electronic integrated circuit and photonic integrated circuit system at a ninth stage of manufacturing;
FIG. 11J depicts a cross-section view of an example embodiment of a hybrid electronic integrated circuit and photonic integrated circuit system at a tenth stage of manufacturing;
FIG. 12 depicts a flow chart of a method according to various embodiments of the subject matter disclosed herein;
FIG. 13 depicts a cross-section view of a hybrid electronic integrated circuit and photonic integrated circuit system according to various embodiments of the subject matter disclosed herein; and
FIG. 14 depicts a cross-section view of a hybrid electronic integrated circuit and photonic integrated circuit system according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Integrated Chip," "First Substrate," "PIC," etc.) may be interchangeably used with a corresponding non-capitalized version (e.g., "integrated chip," "first substrate," "pic," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Disclosed herein are various devices, structures and methods for forming an optical interconnection between devices including both electronic integrated circuits (EICs) and photonic integrated circuits (PICs). In some embodiments, a hybrid transceiver may use a combination of EICs and PICs to transmit and receive optical signals between devices. In some embodiments, a first hybrid transceiver may bi-directionally communicate with a second hybrid transceiver using an optical interconnection.

As used herein, EICs refer to a wide variety of integrated circuits using electrical components. In some embodiments, EICs may include a combination of various electrical components such as transistors, resistors, inductors, and capacitors which in combination form an electronic circuit on a substrate. In some embodiments, EICs may include central processing units (CPUs), logic chips, memory such as static random-access memory (SRAM), dynamic random-access memory (DRAM), application processors (AP), graphical processing units (GPUs), artificial intelligence (AI) chips, high bandwidth memory (HBM) interfaces, and other application-specific integrated circuits (ASIC). In some embodiments, a combination of circuits may be present on a substrate. In some embodiments, EICs may be referred to in terms such as microchips, microcontrollers, silicon chips.

As used herein, PICs refer to a wide variety of integrated circuits using photonic components. In some embodiments, PICs may include a combination of various photonic components such as waveguides, optical filters, gratings, lenses, mirrors, and optical ring resonators. In some embodiments, PICs may include electrical components such as photodiodes, light emitting diodes, and laser diodes. In some embodiments, PICs may be referred to using terms such as integrated optical circuits, and planar light wave circuits.

As used herein, a substrate may be composed of one or more of a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. In some embodiments, a substrate for use in a PIC may be referred to a waveguide. Bonding substrates together may be thus known in some embodiments as die-to-die (D2D) bonding, wafer-to-wafer bonding (W2W) or die-to-wafer bonding (D2W). In some embodiments, a packaged chip may contain multiple substrates, and may include PIC substrates, EIC substrates, or a combination of PIC substrates and EIC substrates. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be connected using a via extending through an interposer such as another substrate or chip. In some embodiments, an interconnection may be formed using connections on a surface of a substrate, such as a pad, and may use additional materials between the pads such as solder to form an interconnection.

In some embodiments, bonding between substrates may involve bonding between metals, or metal-metal bonding. In some embodiments, bonding between substrates may involve bonding between dielectric materials, or dielectric-dielectric bonding. In some embodiments, bonding between substrates may involve both metal-metal and dielectric-dielectric bonding, known as hybrid bonding. A hybrid bonding technique may be used to provide additional connections between opposing surfaces, allowing both dielectric and conductive surfaces to bond, and may increase the mechanical strength of the resulting structure. As used herein, hybrid bonding may be defined as bonding both conductive portions to conductive portions, such as a metal-metal bond, and bonding dielectric portions to dielectric portions such as a dielectric-dielectric bond.

As used herein, multiplexing may refer to a number of techniques for multiplexing optical signals. In some embodiments, multiplexing may refer to wavelength division multiplexing (WDM). In some embodiments, the multiplexing may refer to polarization-based multiplexing. In some embodiments, the multiplexing may refer to optical fiber mode based polarization. In some embodiments, multiplexing may be a combination of one or more of WDM, polarization, and fiber mode polarization.

As used herein, polarization may refer to both linear and circular polarization. Linear polarization modes may be referred to as S and P or transverse-magnetic (TM) and transverse-electric (TE) polarizations. Circular polarizations may be referred to as right-handed polarization (RCP) or left-handed polarization (RCP).

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit.

As used herein, a bridge refers to a substrate, die, or other structure having one or more electrically conductive pathways able to form connection between one or more semiconductor devices, as well as substrates, interposers, or other package structures. A bridge may include one or more electrically conductive traces forming a connection pathway along the bridge between one or more devices coupled to the bridge. An embedded bridge, as used herein, may refer to a bridge in a layer within a semiconductor package, and may be used interchangeably with the term "bridge." An active bridge may refer to a bridge featuring additional features beyond connections, such as transistors, vias, and other circuit components.

Disclosed herein are various embodiments of systems, methods and devices using co-packaging of both EIC and PIC on a base substrate to form a hybrid device. In various embodiments, the supporting substrate may be a glass core substrate, a silicon substrate, or a substrate formed of any other suitable semiconductor material, as well as take the form of a printed circuit board, card, or interposer. A supportive interchange may positioned on top of the supporting substrate, as disclosed herein. In some embodiments, a PIC may be embedded at least partially within the supportive interchange. In some embodiments, an EIC may also be embedded at least partially within the supportive interchange. In some embodiments, the EIC may take the form of one or more compute devices positioned on top of the supportive interchange, the one or more compute devices including compute devices such as memory devices, processing devices, ASICs, and stacks including combinations such as HBMs. A redistribution layer may be positioned at least partially on a PIC embedded at least partially within the supportive interchange. In some embodiments, the supportive interchange may include multiple redistribution layers, with a first redistribution layer below a PIC embedded at least partially within the supportive interchange and providing a connection to the supporting substrate, and a second redistribution layer above a PIC embedded at least partially within the supportive interchange to provide connections to one or more compute devices positioned on top of the supportive interchange. In some embodiments, the one or more compute devices may be encapsulated by a protective material, such as a dielectric and may include epoxies, resin, fillers, and may provide resistance to mechanical, thermal, and electrical shock. In some embodiments, the protective material may be formed from an epoxy molding compound (EMC). In some embodiments, the one or more compute devices may include a first compute device and a second compute device with the PIC positioned between the first compute device and the second compute device. A fiber attach unit (FAU) may be directly connected to the PIC embedded at least partially within the supportive interchange via an opening in the redistribution layer and the protective layer. The FAU may then be positioned between the first compute device and the second compute device. A signal may be received by the FAU and transmitted to the PIC embedded at least partially within the supportive interchange before being transmitted via the redistribution layer to the one or more compute devices.

In some embodiments, the hybrid device may be formed using a method where the supportive interchange is formed by first forming a lower redistribution layer and connections prior to positioning a PIC on the lower redistribution layer. A first sacrificial layer may be formed on top of the PIC, prior to deposition of a first dielectric material, with the first sacrificial layer removed after the planarization of the first dielectric material. An upper redistribution layer may then be formed on top of the PIC and planarized first dielectric material, with an opening formed within upper redistribution layer above the PIC. The one or more compute devices may then be positioned upon the upper redistribution layer along with a second sacrificial layer formed above the opening in the upper redistribution layer. A second dielectric material is deposited to form the protective layer, while the second sacrificial layer is then removed to provide an opening to attach the FAU to the PIC. In some embodiments, the second sacrificial layer may be covered by the second dielectric material, with the second sacrificial layer removed after the second dielectric material.

In some embodiments, the PIC may be in a top mount configuration with the PIC positioned on top of the upper redistribution layer between the first compute device and the second compute device. In a top mount configuration, the PIC may be added after the second redistribution layer is formed, and use a single sacrificial layer removed after the second dielectric layer is formed.

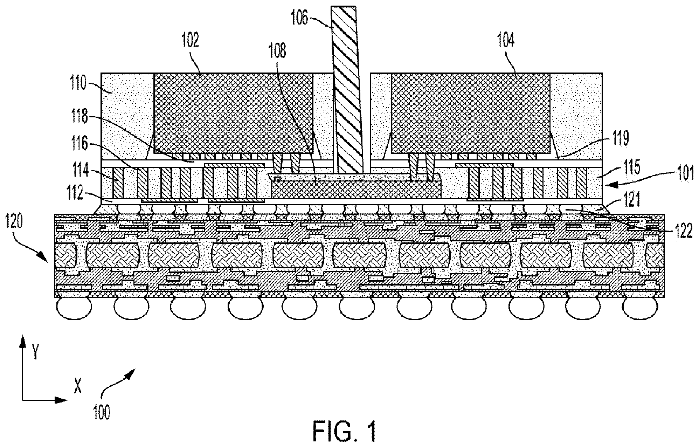

FIG. 1 discloses an exemplary embodiment of an architecture for a first device package architecture 100 formed on a supporting substrate 120. In some embodiments, the supporting substrate 120 may comprise a glass substrate, a glass core substrate, a silicon substrate, or another other suitable substrate, while in other embodiments the supporting substrate 120 may take the form of an interposer, a circuit board, a card or other structure providing electrical signals and routing to the first device package architecture 100. In some embodiments, the first device package architecture 100 includes one or more compute devices positioned thereupon, and may include a first compute device 102 and a second compute device 104. In some embodiments, the devices of the first compute device 102 and the second compute device 104 may be various forms of devices such as memory including DRAM, SRAM, and other forms of memory; a processor including CPU, XPU, GPUs; as well as additional suitable circuits, including ASICs, or combinations thereof. In some embodiments, the first compute device 102 and the second compute device 104 may each comprise a stack of one or more component devices. In some embodiments, the stack of component devices may include one or more memory devices, core devices, and combinations thereof. In some embodiments, a core device may include for example a processor, processing device, or other form of microcontroller to act as a controller. While the exemplary embodiment of FIG. 1 depicts only a first compute device 102 and a second compute device 104, the first device package architecture 100 may include additional devices, for example with the first compute device 102 or the second compute device 102 taking the form an HBM device including multiple memory devices.

The first compute device 102 and the second compute device 102 may be positioned on a supportive interchange 101. The supportive interchange 101 may have the first compute device 102 and the second compute device 104 positioned thereon in a variety of ways and may include pads, bumps, microbumps, pillars, balls, ball grids, microball arrays, and other forms such as controlled-collapse chip connection (C4) bumps, alone or in combination. As used herein, a C4 bump refers to a form of solder bumps placed on pads on a top surface of a substrate prior to flipping the substrate to form a flip-chip. The positioning method may further include a dielectric material, which may include a material such as an adhesive, resin, or elastomer which may form a connection in addition to a conductive connection. In some embodiments, the combination of a conductive connection and a dielectric connection may form a hybrid bond.

The supportive interchange 101 may include an upper redistribution layer 116, also known as the upper RDL 116. The first compute device 102 and the second compute device 102 may be positioned directly on the upper RDL 116, or one or more intermediate layers may be inserted between. The upper RDL 116 may provide one or more layers including a series of pads, bumps, vias, through-vias, traces, and other forms of connection for redistributing electrical signals on the top of the supportive interchange 101. The upper RDL 116 may couple to the first compute device 102 and the second compute device 102, as well as to one or more pillars 114 within the supportive interchange 101. The one or more pillars 114 within the supportive interchange 101 may couple the upper RDL 116 to a PIC 108 at least partially within the supportive interchange 101, as well as couple the upper RDL 116 to a lower redistribution layer or lower RDL 112 on the bottom of the supportive interchange 101, and in some embodiments may take the form of one or more through-vias. The lower RDL 112 may in turn provide one or more layers including a series of pads, bumps, vias, through-vias, traces, and other forms of connection for redistributing signals from connections from the supporting substrate 120 to the one or more pillars 114, the PIC 108, the first compute device 102, and the second compute device 104.

The interconnection between the supportive interchange 101 on the supporting substrate 120 may include conductive materials forming substrate interconnections 122 to couple the supportive interchange 101 to the supporting substrate 120 including pads, bumps, microbumps, pillars, balls, and other forms such as controlled-collapse chip connection C4 bumps, alone or in combination. In some embodiments, a bonding layer 121 may also include a dielectric material or an adhesive, like underfill material, to provide additional strength and connection between the supportive interchange 101 and the supporting substrate 120. In some embodiments, the interconnection may provide a metallic bonding between the supportive interchange 101 and the supporting substrate 120, a dielectric bonding between the supportive interchange 101 and the supporting substrate 120, or in some embodiments a hybrid bonding between the supportive interchange 101 and the supporting substrate 120. In some embodiments, the interconnection may bond directly with the lower RDL 112, while in other embodiments, intermediate layers may between the interconnection and the lower RDL 112.

The one or more pillars 114, the upper RDL 116, the lower RDL 112, and the PIC 108 may be separated by a molding layer 115. The molding layer 115 may provide thermal, electrical, and mechanical protection for the various components in and on the supportive interchange 101. The molding layer 115 may be formed from a dielectric material such as silicon dioxide, resins, adhesives, and epoxies, alone or in combination, and may in some embodiments include an EMC.

In the exemplary embodiment of FIG. 1, the first compute device 102 and the second compute device 104 may be positioned upon the upper RDL 116 using one or more conductive connections 118 and one or more dielectric bonds 119. The one or more conductive connections 118 may include pads, bumps, microbumps, pillars, balls, ball grids, microball arrays, and other forms such as C4 bumps, alone or in combination. The one or more dielectric bonds 119 may include a dielectric material or adhesive between the first compute device 102 or the second compute device 104 and the upper RDL 116, such as an epoxy, a resin, or other suitable material. In some embodiments, the one or more dielectric bonds 119 may be formed using an underfill technique and inserted between the first compute device 102 or the second compute device 104 and the upper RDL 116 and around the one or more conductive connections 118. In some embodiments, the one or more conductive connections 118 and the one or more dielectric bonds 119 may combine to form a hybrid bond between the first compute device 102 or the second compute device 104 and the supportive interchange 101.

In some embodiments, the supportive interchange 101 may have the substrate interconnection 122 formed upon the lower RDL 112. The substrate interconnection 122 may electrically connect the supportive interchange 101 to the supporting substrate 120. In some embodiments, the substrate interconnection 122 may include a conductive bond, a dielectric bond, or a hybrid bond. In some embodiments, a conductive bond may include pads, bumps, microbumps, pillars, balls, ball grids, microball arrays, and other forms such as C4 bumps, alone or in combination. In some embodiments, a dielectric bond may include a dielectric material such as silicon dioxide, resins, adhesives, and epoxies, alone or in combination. In some embodiments, the dielectric material may take the form of an underfill and be introduced between the supportive interchange 101 and the supporting substrate 120 in conjunction with a conductive bond, and may form a hybrid bond between the supportive interchange 101 and the supporting substrate 120.

In some embodiments, the supportive interchange 101 may also include one or more photonic integrated circuits embedded within. In the exemplary embodiment of FIG. 1, a PIC 108 is embedded within the supportive interchange 101. The PIC 108 may, in some embodiments, be positioned on directly to the lower RDL 112, while in other embodiments, an attach film may be located between the lower RDL 112 and the PIC 108. In some embodiments, the attach film may be formed from an adhesive material such as a resin or epoxy, a metal layer, a dielectric material, or any other suitable material to form one or more layers to allow the PIC 108 to position on the lower RDL 112. In some embodiments, the PIC 108 may be a single PIC, while in other embodiments, the PIC 108 may include additional PICs, an EIC, a die, a bridge, or some other suitable element for forming a connection between two circuits, or in a combination thereof. The PIC 108 may, in some embodiments, be coupled directly to the first compute device 102 or the second compute device 104, while in other embodiments the upper RDL 116 couples to the PIC 108 to one or both of the first compute device 102 and the second compute device 104. The PIC 108 may, in some embodiments, act as a bridging element to provide a communicative connection coupling the first compute device 102 and the second compute device 104.

The PIC 108 may take the form of one or more layers of optical components upon an optical substrate, for example glass, polymer, and silicon oxide. In some embodiments, one or more buried oxide layers or BOX layers may be formed upon an optical substrate and contain various photonic device components, which may be referred to as the active layer. The PIC 108, may, in some embodiments, include components for modulating the optical signals such as micro-ring resonators, serializers, phase shifters, couplers, lenses, polarizers, gratings, anti-reflection coatings, filters, index matching coatings, mirrors, delay lines, and a variety of other photonic elements both passive and active. An optical signal may, in some embodiments, be generated from an external source and provided to the PIC 108, while in other embodiments, the PIC 108 may include a light generation source such as a laser comb source such as a four-wave-mixing-based frequency comb, a Kerr frequency comb, or any other suitable technique for generating a comb signal. As used herein, a comb signal refers to an optical signal having a plurality of wavelengths separated into discrete spectra. The photonic components of the PIC 108 may modulate, redirect, combine, separate and otherwise modify an optical signal within the PIC 108. In some embodiments, the PIC 108 may include one or more layers of electrical components, and in some embodiments may provide a bridge connecting the first compute device 102 and the second compute device 104. In some embodiments, the PIC 108 may include additional electronic circuitry, such as a logic structure for routing electrical signals from the PIC 108 to the rest of the first device package architecture 100.

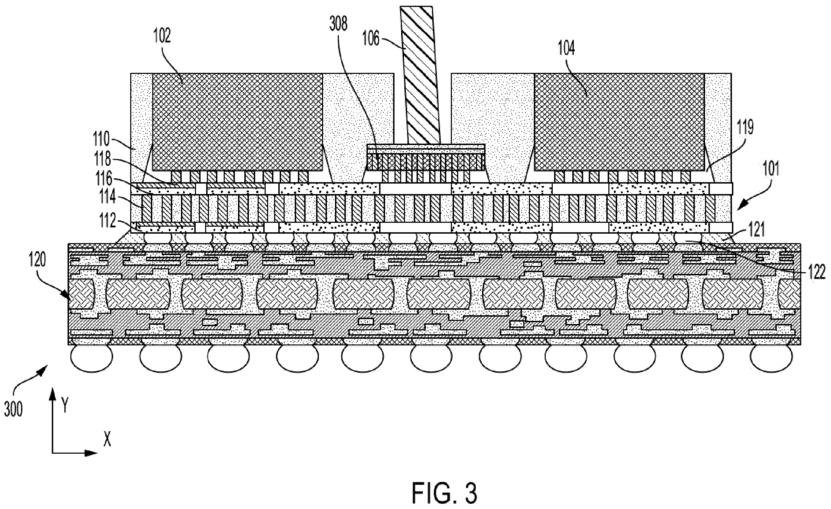

In some embodiments, either the first compute device 102 or the second compute device 104 may provide the driving electronics for the PIC 108, including heater control circuits, heater drivers, modulator drivers, and serializers to modify the optical signal within the PIC 108. For example, if the PIC 108 includes one or more micro-ring resonators, heaters may be integrated with the one or more micro-ring resonators to provide control over the resonance frequency of the one or more micro-ring resonators by altering the physical characteristics of the one or more micro-ring resonators. While portions of the heaters may be formed within the PIC 108, the electronics controlling and regulating the heaters are within the first compute device 102 or the second compute device 104 separate from the PIC 108. Furthermore, the PIC 108 may include one or more photodetectors to receive an optical signal, which may be transmitted to the first compute device 102 or the second compute device 104 for further signal processing, including amplification, analog to digital conversion, rectification, or any other suitable signal processing techniques. In some embodiments, some or all of the driving electronics for the PIC 108 may be transferred from the first compute device 102 or the second compute device 104 to another device, such as an additional EIC which may connect directly to the supportive interchange 101, or via the supporting substrate 120. In some embodiments, as discussed in more detail below with respect to FIG. 3, the PIC 108 may include one or more vias extending through the PIC 108 to couple elements of the active layer to the rest of the supportive interchange 101.

In some embodiments, an encapsulation layer 110 may be formed over the first compute device 102, the second compute device 104 and the supportive interchange 101 and at least partially surround the compute devices. The encapsulation layer 110 may take the form of a dielectric material such as silicon dioxide, resins, adhesives, and epoxies, alone or in combination, and may in some embodiments include an EMC. In some embodiments, the encapsulation layer 110 may provide mechanical support, such as holding the devices in places, as well as may provide electrical isolation, and may provide a thermal path for heat from the devices to transfer via. The encapsulation layer 110 may, in some embodiments, comprise one or more encapsulation layers, and may include individual encapsulation layers to encapsulate the first compute device 102 and the second compute device 104.

In some embodiments, a first optical connection 106 may connect to the PIC 108. In some embodiments, the first optical connection 106 may be a fiber optic, an optical connector, a FAU, a pluggable optical connector, a plug connector, a v-groove, as well as combinations thereof and various arrays thereof. In some embodiments, the optical fiber may be unidirectional, allowing only transmitting or receiving, while in other embodiments, the optical fiber may be a bi-directional fiber. In some embodiments, additional optical elements may be placed between the first optical connection 106 and the PIC 108, such as polarizers, gratings, anti-reflection coatings, filters, index matching coatings, lenses, and any other suitable optical components, alone or in a combination thereof. In some embodiments, the first optical connection 106 may allow the first device package architecture 100 to transmit optical signals, to receive optical signals, or both receive and transmit optical signals. In some embodiments, the first optical connection 106 may include a plurality of optical connections, including a receiving optical connection to receive incoming optical signals, and a transmitting optical connection to transmit outgoing optical signals. In some embodiments, the plurality of optical connections may include one or more separated optical connections, the separated optical connections corresponding to one or more multiplexing methods, for example, wavelength-based multiplexing, fiber mode based multiplexing, polarization based multiplexing, and combinations thereof. In some embodiments, the first optical connection 106 may provide an optical coupling for optical signals to one or more additional systems, including additional computational systems, networks, remote computers, and any other suitable optical devices.

In some embodiments, the first optical connection 106 may connect to the PIC 108 via an opening in the encapsulation layer 110. In some embodiments, the first optical connection 106 may also connect to the PIC 108 via an opening in the upper RDL 116. The first optical connection 106 may be placed between the first compute device 102 and the second compute device 104 to reach the PIC 108 also between the first compute device 102 and the second compute device 104. In some embodiments, the placement of the PIC 108 in the central area between the first compute device 102 and the second compute device 104 may reduce the distance for signals to travel from the PIC 108 to the first compute device 102 and the second compute device 104, and may improve latency, reduce power consumption, and provide improvements to speed.

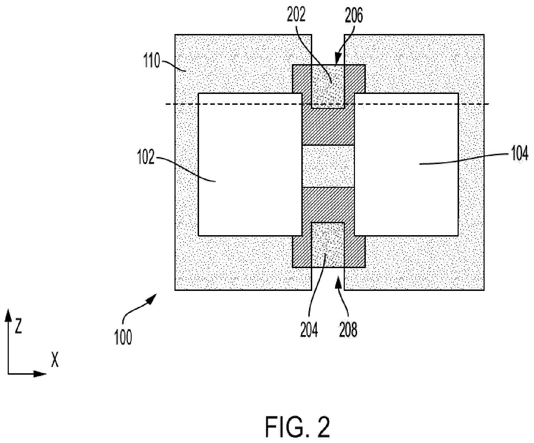

FIG. 2 depicts a plan view of the first device package architecture 100 according to an exemplary embodiment. FIG. 2 provides a plan view from above of the first device package architecture 100, with the first compute device 102 and the second compute device 104 largely surrounded by the encapsulation layer 110 and covering the supportive interchange 101. FIG. 2 also demonstrates that in some embodiments, the PIC 108 may take the form of a first PIC 202 and a second PIC 204. In some embodiments, the first PIC 202 may transmit optical signals while the second PIC 204 may receive optical signals, while in other embodiments, the first PIC 202 may receive while the second PIC 204 may transmit, and in yet more embodiments both the first PIC 202 and the second PIC 204 may be transducers able to provide both transmission and reception. In some embodiments, the first PIC 202 and the second PIC 204 may handle incoming and outgoing optical signals to the first device package architecture 100, providing communications via optical communications such as the first optical connection 106 to additional optical devices, such as routers, optical networks, and between multiple iterations of the first device package architecture 100.

Above the first PIC 202 may be a first opening 206 in the encapsulation layer 110, while a second opening 208 in the encapsulation layer 110 may be above the second PIC 204. In some embodiments, the first opening 206 and the second opening 208 may be joined by additional openings for further optical connections, while in other embodiments, the first opening 206 and the second opening 208 may form a single unitary opening. The first PIC 202 may thus be reached by an optical connection such as the first optical connection 106 via the first opening 206, while the second PIC 204 may thus be reached by an optical connection such as the first optical connection 106 via the second opening 208.

In an embodiment such as illustrated in FIG. 2, the first opening 206 and the second opening 208 may each be sized to fit an optical connection, and may thus reduce the portions of the first device package architecture 100 not covered by the encapsulation layer 110. In some embodiments, the encapsulation layer 110 may protect the rest of the first device package architecture 100 from one or more of mechanical, thermal and electrical disturbances, and thus reducing the portions of the first device package architecture 100 exposed may reduce potential damage to the first device package architecture 100.

FIG. 3 depicts an illustrative embodiment of a second device package architecture 300. The second device package architecture 300 of FIG. 3 differs from the first device package architecture 100 of FIG. 1, by positioning the PIC 108 on top of the supportive interchange 101 rather than within the supportive interchange 101. Thus, in the embodiment of FIG. 3, the PIC 108 is replaced with the top PIC 308 positioned on the upper RDL 116, rather than between the upper RDL 116 and the lower RDL 112. As such, for the embodiment illustrated in FIG. 3, there is no opening formed within the upper RDL 116 to reach the PIC 108. The top PIC 308 may include one or more vias extending through-out, the one or more vias providing a pathway for signals to reach an active layer on an upper surface of the top PIC 308. The active layer may be one or more layers where active optical elements for use within the photonic circuits such as heaters, switches, lenses, etc. are formed.

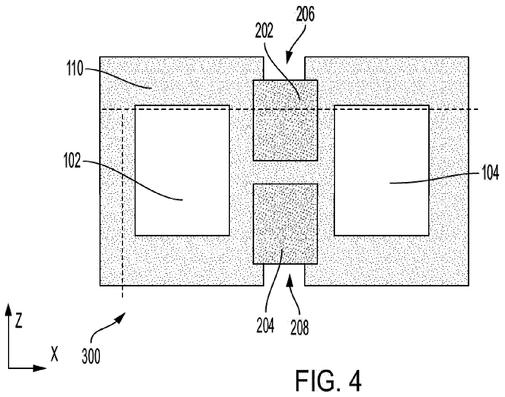

FIG. 4 depicts a plan view of the second device package architecture 300 according to an exemplary embodiment. FIG. 4 provides a plan view from above of the second device package architecture 300, with the first compute device 102 and the second compute device 104 largely surrounded by the encapsulation layer 110 and covering the supportive interchange 101. As with the example embodiment of FIG. 2, the PIC 108 may include the first PIC 202 and the second PIC 204 with the first opening 206 above the first PIC 202 and the second opening 208 above the second PIC 204. In FIG. 4, the second device package architecture 300 may, in some embodiments, have the first compute device 102 and the second compute device 104 spaced apart further laterally than in the first device package architecture 100. In the second device package architecture 300, the first compute device 102 and the second compute device 104 share the upper surface of the supportive interchange 101 with the PIC 108. In contrast, in an embodiment such that as FIG. 1 and FIG. 2, when the PIC 108 is embedded within the supportive interchange 101, the first compute device 102 and the second compute device 104 may be spaced closer together, as both the first compute device 102 and the second compute device 104 may laterally overlap the PIC 108. In FIG. 3 and FIG. 4 however, the PIC 108 and the top PIC 308 may be directly between the first compute device 102 and the second compute device 104, and thus the size of the second device package architecture 300 may be larger in the lateral directions from the first device package architecture 100. However, the second device package architecture 300 may have a decreased height from the first device package architecture 100, as the supportive interchange 101 in the second device package architecture 300 may be shorter than the supportive interchange 101 in the first device package architecture 100, as the PIC 108 is on top of the supportive interchange 101.The lateral and vertical dimensions of device package architectures may be further adjusted as needed, for example to fit within a given space or to allow a denser packing of devices in a preferred dimension.

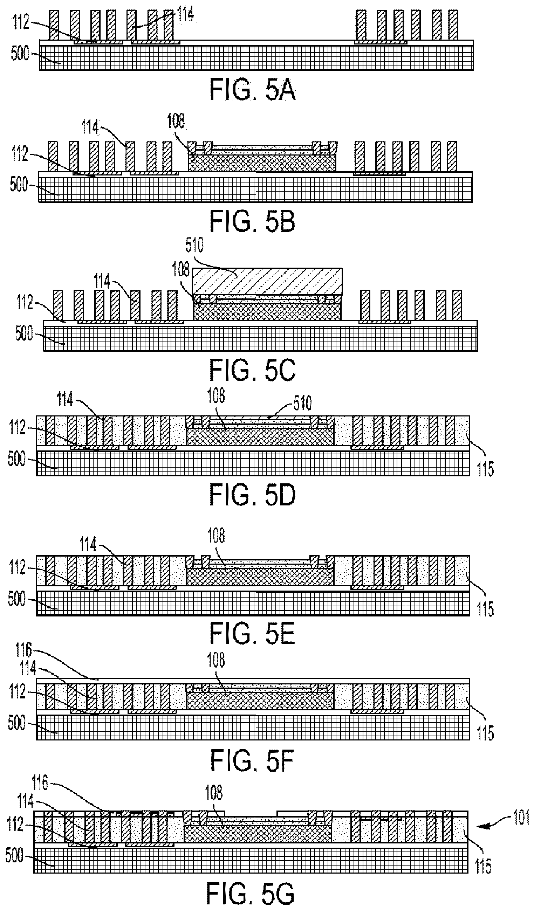

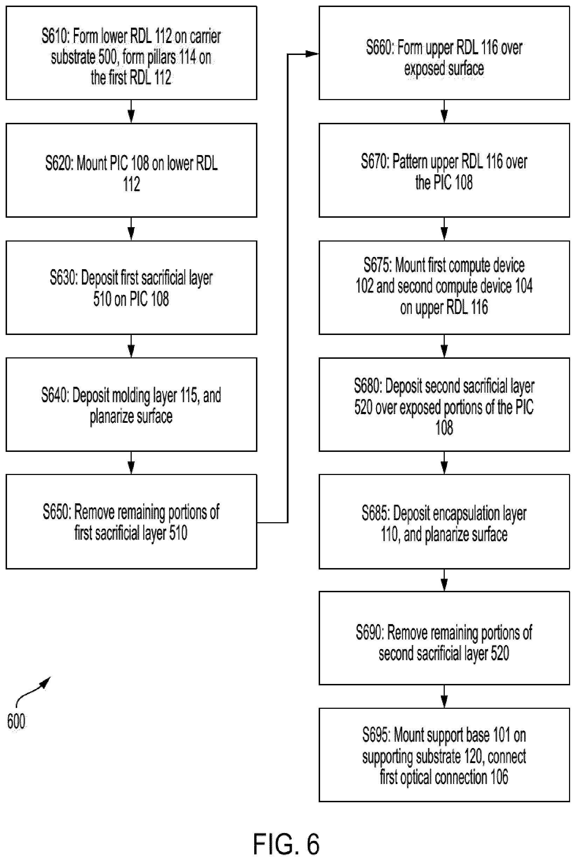

FIGS. 5A-5L depict an illustrative embodiment of a process of forming a device package architecture such as the first device package architecture 100, or any other device package architectures shown herein. FIG. 6 depicts an example embodiment of a process 600 for forming a device package assembly corresponding to the illustrative embodiment of FIGS. 5A-5L.

FIG. 5A depicts S610 in the process of FIG. 6 where formation of the supportive interchange 101 begins on a carrier substrate 500 with the formation of the lower RDL 112. The carrier substrate 500 may be any suitable substrate, such as a glass substrate. In some embodiments, prior to the lower RDL 112 being formed on the carrier substrate 500, a release layer (not shown) may be formed on the carrier substrate 500. The release layer may comprise a material such as a polymer, wax, epoxy, or resin which acts as a sacrificial layer and may be cleanly removed from the carrier substrate 500 and the lower RDL 112. In some embodiments, the lower RDL 112 may be formed using complementary metal-oxide-semiconductor (CMOS) processes, such as depositing, lithography, etching, including both wet etch and dry etch, passivation directly on the carrier substrate 500. In some embodiments, the lower RDL 112 may be formed on a separate substrate and transferred to the carrier substrate 500. In addition, S610 depicts the formation of pillars 114 on the lower RDL 112. The pillars 114 may comprise a conductive material, including metals such as copper, as well as other known conductive materials, such as doped carbon. The pillars 114 are bonded to the lower RDL 112 and may form an interconnection layer for the upper RDL 116 added later. In some embodiments, the pillars 114 may be bonded using metal diffusion bonding between a metallic material forming the pillars 114 and corresponding metal materials within the lower RDL 112.

FIG. 5B depicts S620 in the process of FIG. 6 where the PIC 108 is positioned on the lower RDL 112. In some embodiments, the PIC 108 may be positioned directly on the lower RDL 112, while in other embodiments, a die attach film may be placed prior to positioning the PIC 108. A die attach film may, for example, include one or more dielectric materials to enable coupling to metal layers within the lower RDL 112. The PIC 108 may take the form of one or more layers of optical components upon an optical substrate, for example glass, polymer, and silicon oxide. In some embodiments, the PIC 108 may additionally include one or more layers of electrical circuit components, such as logic and support circuitry for the optical elements of the PIC 108. The PIC 108 may, in some embodiments, include multiple PICs formed in parallel as discussed with respect to FIG. 2 and FIG. 4.

FIG. 5C depicts S630 in the process of FIG. 6 where a first sacrificial layer 510 is formed over the PIC 108. The first sacrificial layer 510 may be formed by a material suitable for patterning, such as a photoresist material patterned by photolithography, as well as a dielectric material which may be patterned by a process such depositing the material over a mask or etch process to selectively deposit or remove the material. The first sacrificial layer 510 may be selectively formed over only the PIC 108, and leave the pillars 114 and the lower RDL 112 exposed.

FIG. 5D depicts S640 in the process of FIG. 6 where the molding layer 115 is deposited over the pillars 114, the lower RDL 112 and the first sacrificial layer 510 and then planarized. The molding layer 115 may be chosen from a different material than used for the first sacrificial layer 510, such that a process may easily remove the material of the first sacrificial layer 510 while leaving the molding layer 115 intact. For example, in some embodiments, the molding layer 115 may be a dielectric such as silicon oxide or silicon nitride, while the first sacrificial layer 510 may be formed of a different dielectric such as silicon carbide which may response to different etchants. After the deposition of the molding layer 115, the pillars 114, the lower RDL 112, the molding layer 115 and the first sacrificial layer 510 may be subject to a process to smooth and or planarize the surface, the process including one or more grinding, polishing, and smoothing processes, including chemical mechanical polishing (CMP). The planarization may be such that only a portion of the first sacrificial layer 510 may remain.

FIG. 5E depicts S650 in the process of FIG. 6 where remaining portions of the first sacrificial layer 510 may be removed. In some embodiments, the first sacrificial layer 510 may be removed by exposure of the first sacrificial layer 510 to an appropriate form of energy, for example ultraviolet light for a photo sensitive material. In some embodiments, the first sacrificial layer 510 may be removed using an etch process including either a wet etch or a dry etch process, for example where the material of the first sacrificial layer 510 differs from that of both the PIC 108 and the molding layer 115 such that a selective etch may remove the first sacrificial layer 510 without effecting either the PIC 108 or the molding layer 115. Upon removal of the first sacrificial layer 510, the surface of the PIC 108 may be exposed.

FIG. 5F depicts S660 in the process of FIG. 6 where the upper RDL 116 is formed over the PIC 108, the molding layer 115 and the pillars 114, also known as the embedded layers. In some embodiments, the upper RDL 116 may be formed using complementary metal-oxide-semiconductor (CMOS) processes, such as depositing, lithography, etching, passivation directly on the carrier substrate 500. In some embodiments, the upper RDL 116 may be formed on a separate substrate and transferred to the carrier substrate 500. The upper RDL 116 includes a series of pads, bumps, vias, through-vias, traces, and other forms of connection for redistributing signals from the embedded layers to an appropriate location on the top of upper RDL 116. In some embodiments, a portion of the molding layer 115 may be exposed to provide a suitable dielectric surface for forming hybrid bonds. The formation of the upper RDL 116 with the lower RDL 112, and the components between thus may be referred to as the supportive interchange 101.

FIG. 5G depicts S670 in the process of FIG. 6 where a portion of the upper RDL 116 is removed over the PIC 108. The removed portion of the upper RDL 116 may be removed by any suitable method known in the art including laser scribing, dry etch, wet etch, lithography, mechanical remove, etc. The portion of the upper RDL 116 is removed over a portion of the PIC 108 suitable for coupling to the first optical connection 106.

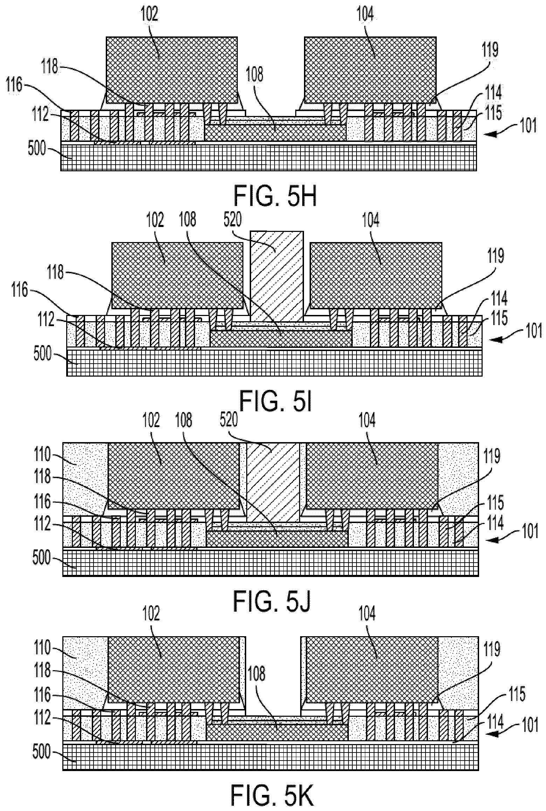

FIG. 5H depicts S680 in the process of FIG. 6 where the first compute device 102 and the second compute device 104 are positioned on the upper RDL 116. The first compute device 102 and the second compute device 104 may be positioned upon the upper RDL 116 using one or more conductive connections 118 and one or more dielectric bonds 119. The one or more conductive connections 118 may include pads, bumps, microbumps, pillars, balls, ball grids, microball arrays, and other forms such as C4 bumps, alone or in combination. The one or more dielectric bonds 119 may include a dielectric material or adhesive between the first compute device 102 or the second compute device 104 and the upper RDL 116, such as an epoxy, a resin, or other suitable material. In some embodiments, the one or more dielectric bonds 119 may be formed using an underfill technique and inserted between the first compute device 102 or the second compute device 104 and the upper RDL 116 and around the one or more conductive connections 118. In some embodiments, the one or more conductive connections 118 and the one or more dielectric bonds 119 may combine to form a hybrid bond between the first compute device 102 or the second compute device 104 and the supportive interchange 101. In some embodiments, the first compute device 102 and the second compute device 104 may be positioned directly on the PIC 108, while in other embodiments the upper RDL 116 may be between the first compute device 102 and the second compute device 104 and the PIC 108.

FIG. 5I depicts S680 in the process of FIG. 6 where a second sacrificial layer 520 is deposited over the PIC 108. The second sacrificial layer 520 may be formed by a material suitable for patterning, such as a photoresist material patterned by photolithography, as well as a dielectric material which may be patterned by a process such depositing the material over a mask or etch process to selectively deposit or remove the material. The second sacrificial layer 520 may be selectively formed over only the PIC 108, and leave the first compute device 102, the second compute device 104 and any additional portions of the upper RDL 116 exposed.

FIG. 5J depicts S680 in the process of FIG. 6 where the encapsulation layer 110 is deposited over the first compute device 102, the second compute device 104, the second sacrificial layer 520 and any additional portions of the upper RDL 116 before being then planarized. The encapsulation layer 110 may be chosen from a different material than used for the second sacrificial layer 520 such that a process may easily remove the material of the second sacrificial layer 520 while leaving the encapsulation layer 110 intact. For example, in some embodiments, the encapsulation layer 110 may be an EMC, while the second sacrificial layer 520 may be formed of a dielectric such as silicon carbide which may response to different etchants, while in other embodiments, the second sacrificial layer 520 may be a photoresist material. After the deposition of the encapsulation layer 110, the encapsulation layer 110 and the second sacrificial layer 520 may be subject to a process to smooth and or planarize the surface, the process including one or more grinding, polishing, and smoothing processes, including chemical mechanical polishing (CMP). In some embodiments, the planarization may be sufficient to expose the first compute device 102 and the second compute device 104, while in other embodiments at least one of the first compute device 102 and the second compute device 104 may be at least partially covered by a portion of the encapsulation layer 110.

FIG. 5K depicts S680 in the process of FIG. 6 where the second sacrificial layer 520 is removed, exposing at least a portion of the PIC 108. In some embodiments, the second sacrificial layer 520 may be removed by exposure of the second sacrificial layer 520 to an appropriate form of energy, for example ultraviolet light for a photo sensitive material. In some embodiments, the second sacrificial layer 520 may be removed using an etch process including either a wet etch or a dry etch process, for example where the material of the second sacrificial layer 520 differs from that of both the PIC 108 and the encapsulation layer 110 such that a selective etch may remove the second sacrificial layer 520 without effecting either the PIC 108 or the encapsulation layer 110.

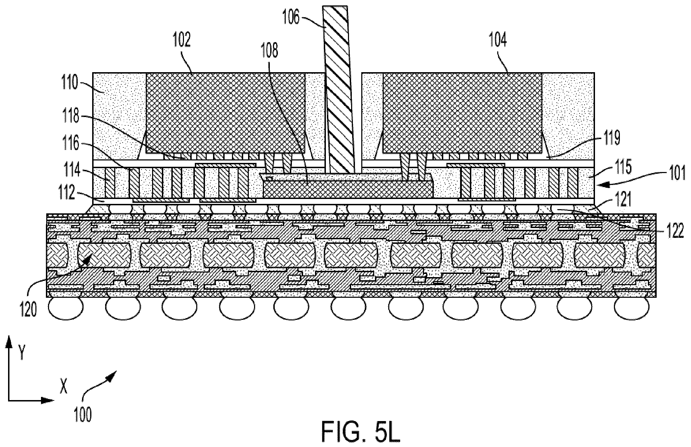

FIG. 5L depicts S680 in the process of FIG. 6 where the supportive interchange 101 is positioned on the supporting substrate 120 and the PIC 108 is connected to the first optical connection 106. The interconnection between the supportive interchange 101 on the supporting substrate 120 may include substrate interconnections 122 to couple the supportive interchange 101 to the supporting substrate 120 including pads, bumps, microbumps, pillars, balls, and other forms such as controlled-collapse chip connection C4 bumps, alone or in combination. In some embodiments, the bonding layer 121 may also include a dielectric material or an adhesive, like underfill material, to provide additional strength and connection between the supportive interchange 101 and the supporting substrate 120. In some embodiments, the interconnection may provide a metallic bonding between the supportive interchange 101 and the supporting substrate 120, a dielectric bonding between the supportive interchange 101 and the supporting substrate 120, or in some embodiments a hybrid bonding between the supportive interchange 101 and the supporting substrate 120. In some embodiments, the interconnection may bond directly with the lower RDL 112, while in other embodiments, intermediate layers may be between the interconnection and the lower RDL 112. In some embodiments, a dielectric material or adhesive material may be inserted using an underfill technique and form the bonding layer 121 on the surface of the supporting substrate 120. In some embodiments, a heat treatment or other thermal process may be provided to strengthen the bond between the supporting substrate 120 and the supportive interchange 101.

When the supportive interchange 101 is positioned on the supporting substrate 120, the first optical connection 106 may be coupled to the PIC 108. In some embodiments, the first optical connection 106 may be directly coupled to the PIC 108, while in other embodiments one or more intermediate optical components may inserted between the first optical connection 106 and the PIC 108, such as lenses, polarizers, filters, etc. In some embodiments, the first optical connection 106 may be a FAU, a pluggable optical connector, a plug connector, a v-groove, as well as combinations thereof and various arrays thereof. In some embodiments, the PIC 108 may have a corresponding coupling location to the first optical connection 106 directly on the PIC 108, while in other embodiments, an intermediate coupler may be inserted.

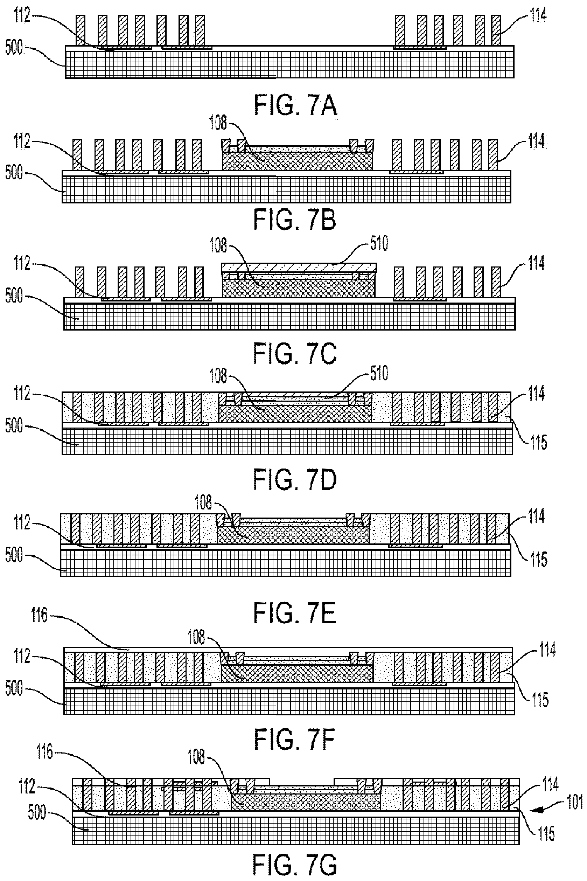

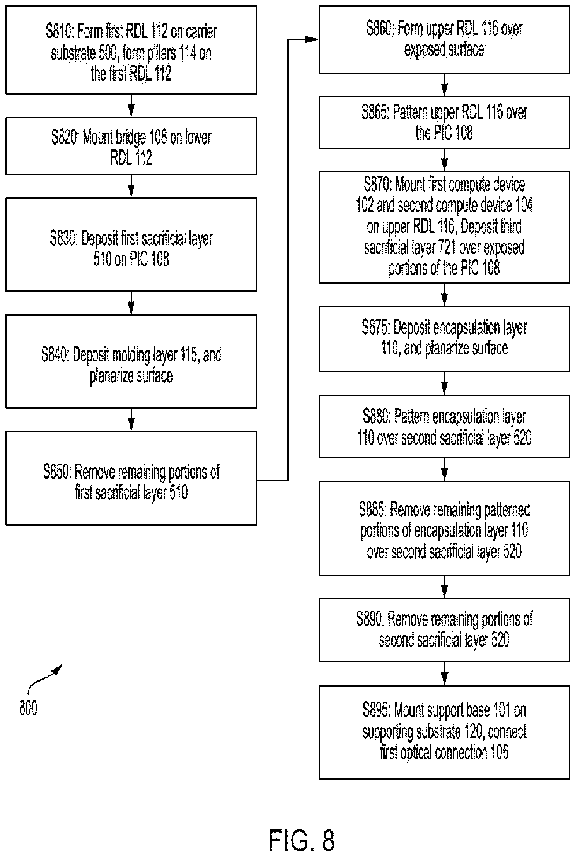

FIGS. 7A-7M depict an illustrative embodiment of a process of forming a device package architecture such as the first device package architecture 100, or any other device package architectures shown herein. FIG. 8 depicts an example embodiment of a process 800 for forming a device package assembly corresponding to the illustrative embodiment of FIGS. 7A-7M.

FIG. 7A depicts S810 in the process of FIG. 8 where formation of the supportive interchange 101 begins on a carrier substrate 500 with the formation of the lower RDL 112. The carrier substrate 500 may be any suitable substrate, such as a glass substrate. In some embodiments, prior to the lower RDL 112 being formed on the carrier substrate 500, a release layer (not shown) may be formed on the carrier substrate 500. The release layer may comprise a material such as a polymer, wax, epoxy, or resin which acts as a sacrificial layer and may be cleanly removed from the carrier substrate 500 and the lower RDL 112. In some embodiments, the lower RDL 112 may be formed using complementary metal-oxide-semiconductor (CMOS) processes, such as depositing, lithography, etching, including both wet etch and dry etch, passivation directly on the carrier substrate 500. In some embodiments, the lower RDL 112 may be formed on a separate substrate and transferred to the carrier substrate 500. In addition, S610 depicts the formation of pillars 114 on the lower RDL 112. The pillars 114 may comprise a conductive material, including metals such as copper, as well as other known conductive materials, such as doped carbon. The pillars 114 are bonded to the lower RDL 112 and may form an interconnection layer for the upper RDL 116 added later. In some embodiments, the pillars 114 may be bonded using metal diffusion bonding between a metallic material forming the pillars 114 and corresponding metal materials within the lower RDL 112.

FIG. 7B depicts S820 in the process of FIG. 8 where the PIC 108 is positioned on the lower RDL 112. In some embodiments, the PIC 108 may be positioned directly on the lower RDL 112, while in other embodiments, a die attach film may be placed prior to positioning the PIC 108. A die attach film may, for example, include one or more dielectric materials to enable coupling to metal layers within the lower RDL 112. The PIC 108 may take the form of one or more layers of optical components upon an optical substrate, for example glass, polymer, and silicon oxide. In some embodiments, the PIC 108 may include additionally one or more layers of electrical circuit components, such as logic and support circuitry for the optical elements of the PIC 108. The PIC 108 may, in some embodiments, include multiple PICs formed in parallel as discussed with respect to FIG. 2 and FIG. 4.

FIG. 7C depicts S830 in the process of FIG. 8 where a first sacrificial layer 510 is formed over the PIC 108. The first sacrificial layer 510 may be formed by a material suitable for patterning, such as a photoresist material patterned by photolithography, as well as a dielectric material which may be patterned by a process such depositing the material over a mask or etch process to selectively deposit or remove the material. The first sacrificial layer 510 may be selectively formed over only the PIC 108, and leave the pillars 114 and the lower RDL 112 exposed.

FIG. 7D depicts S840 in the process of FIG. 8 where the molding layer 115 is deposited over the pillars 114, the lower RDL 112 and the first sacrificial layer 510 and then planarized. The molding layer 115 may be chosen from a different material than used for the first sacrificial layer 510, such that a process may easily remove the material of the first sacrificial layer 510 while leaving the molding layer 115 intact. For example, in some embodiments, the molding layer 115 may be a dielectric such as silicon oxide or silicon nitride, while the first sacrificial layer 510 may be formed of a different dielectric such as silicon carbide which may response to different etchants. After the deposition of the molding layer 115, the pillars 114, the lower RDL 112, the molding layer 115 and the first sacrificial layer 510 may be subject to a process to smooth and or planarize the surface, the process including one or more grinding, polishing, and smoothing processes, including chemical mechanical polishing (CMP). The planarization may be such that only a portion of the first sacrificial layer 510 may remain.

FIG. 7E depicts S850 in the process of FIG. 8 where remaining portions of the first sacrificial layer 510 may be removed. In some embodiments, the first sacrificial layer 510 may be removed by exposure of the first sacrificial layer 510 to an appropriate form of energy, for example ultraviolet light for a photo sensitive material. In some embodiments, the first sacrificial layer 510 may be removed using an etch process including either a wet etch or a dry etch process, for example where the material of the first sacrificial layer 510 differs from that of both the PIC 108 and the molding layer 115 such that a selective etch may remove the first sacrificial layer 510 without effecting either the PIC 108 or the molding layer 115. Upon removal of the first sacrificial layer 510, the surface of the PIC 108 may be exposed.

FIG. 7F depicts S860 in the process of FIG. 8 where the upper RDL 116 is formed over the PIC 108, the molding layer 115 and the pillars 114, also known as the embedded layers. In some embodiments, the upper RDL 116 may be formed using complementary metal-oxide-semiconductor (CMOS) processes, such as depositing, lithography, etching, passivation directly on the carrier substrate 500. In some embodiments, the upper RDL 116 may be formed on a separate substrate and transferred to the carrier substrate 500. The upper RDL 116 includes a series of pads, bumps, vias, through-vias, traces, and other forms of connection for redistributing signals from the embedded layers to an appropriate location on the top of upper RDL 116. In some embodiments, a portion of the molding layer 115 may be exposed to provide a suitable dielectric surface for forming hybrid bonds. The formation of the upper RDL 116 with the lower RDL 112, and the components between thus may be referred to as the supportive interchange 101.

FIG. 7G depicts S865 in the process of FIG. 8 where a portion of the upper RDL 116 is removed over the PIC 108. The removed portion of the upper RDL 116 may be removed by any suitable method known in the art including laser scribing, dry etch, wet etch, lithography, mechanical remove, etc. The portion of the upper RDL 116 is removed over a portion of the PIC 108 suitable for coupling to the first optical connection 106.

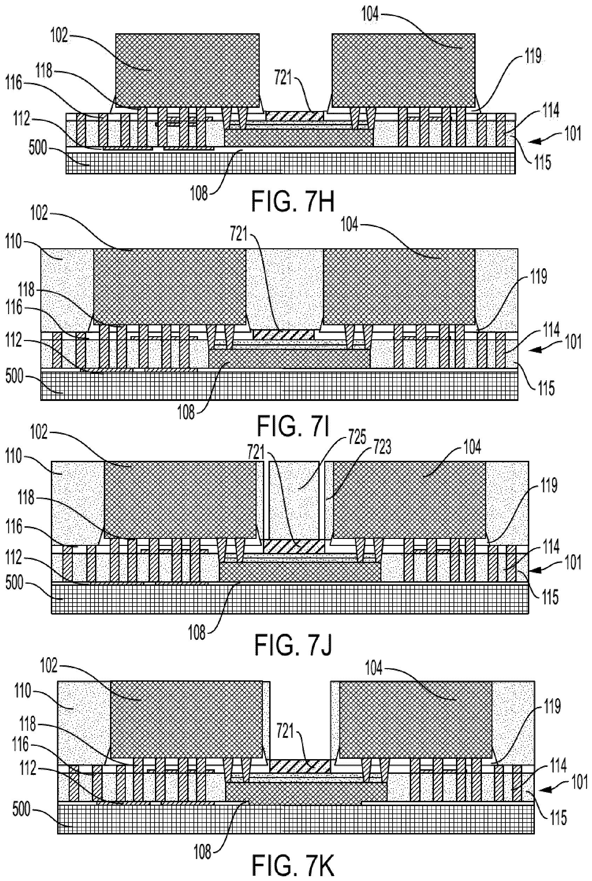

FIG. 7H depicts S870 in the process of FIG. 8 where the first compute device 102 and the second compute device 104 are positioned on the upper RDL 116. The first compute device 102 and the second compute device 104 may be positioned upon the upper RDL 116 using one or more conductive connections 118 and one or more dielectric bonds 119. The one or more conductive connections 118 may include pads, bumps, microbumps, pillars, balls, ball grids, microball arrays, and other forms such as C4 bumps, alone or in combination. The one or more dielectric bonds 119 may include a dielectric material or adhesive between the first compute device 102 or the second compute device 104 and the upper RDL 116, such as an epoxy, a resin, or other suitable material. In some embodiments, the one or more dielectric bonds 119 may be formed using an underfill technique and inserted between the first compute device 102 or the second compute device 104 and the upper RDL 116 and around the one or more conductive connections 118. In some embodiments, the one or more conductive connections 118 and the one or more dielectric bonds 119 may combine to form a hybrid bond between the first compute device 102 or the second compute device 104 and the supportive interchange 101.

In addition, FIG. 7H where a third sacrificial layer 721 is deposited over the PIC 108. The third sacrificial layer 721 may be formed by a material suitable for patterning, such as a photoresist material patterned by photolithography, as well as a dielectric material which may be patterned by a process such depositing the material over a mask or etch process to selectively deposit or remove the material. The third sacrificial layer 721 may be selectively formed over only the PIC 108, and leave the first compute device 102, the second compute device 104 and any additional portions of the upper RDL 116 exposed. The third sacrificial layer 721, unlike the second sacrificial layer 520, may be formed such as to fill the openings within the upper RDL 116, instead of filling the space between the first compute device 102 and the second compute device 104. In some embodiments, the third sacrificial layer 721 may be formed of the same material as the second sacrificial layer 520, while in other embodiments, the materials may differ.

FIG. 7I depicts S875 in the process of FIG. 8 where the encapsulation layer 110 is deposited over the first compute device 102, the second compute device 104, the third sacrificial layer 721 and any additional portions of the upper RDL 116 before being then planarized. The encapsulation layer 110 may be chosen from a different material than used for the third sacrificial layer 721 such that a process may easily remove the material of the third sacrificial layer 721 while leaving the encapsulation layer 110 intact. For example, in some embodiments, the encapsulation layer 110 may be an EMC, while the third sacrificial layer 721 may be formed of a dielectric such as silicon carbide which may response to different etchants, while in other embodiments, the third sacrificial layer 721 may be a photoresist material. After the deposition of the encapsulation layer 110, the encapsulation layer 110 and the third sacrificial layer 721 may be subject to a process to smooth and or planarize the surface, the process including one or more grinding, polishing, and smoothing processes, including chemical mechanical polishing (CMP). In some embodiments, the planarization may be sufficient to expose the first compute device 102 and the second compute device 104, while in other embodiments at least one of the first compute device 102 and the second compute device 104 may be at least partially covered by a portion of the encapsulation layer 110.

FIG. 7J depicts S880 in the process of FIG. 8 where portions of the encapsulation layer 110 over the third sacrificial layer 721 are removed to form one or more gaps 723, exposing at least a portion of the third sacrificial layer 721 and forming a monolith 725. In some embodiments, the portion of the encapsulation layer 110 over the third sacrificial layer 721 may be removed by exposure to an appropriate form of energy, for example a laser light of an appropriate wavelength, such as a UV-laser to form the one or more gaps 723 as a series of holes. In some embodiments, encapsulation layer 110 may be removed using an etch process including either a wet etch or a dry etch process, for example where the material of the third sacrificial layer 721 differs from that of both the PIC 108 and the encapsulation layer 110 such that a selective etch may remove the encapsulation layer 110 without effecting either the PIC 108 or the third sacrificial layer 721.

FIG. 7K depicts S885 in the process of FIG. 8 where the monolith 725, which is the remaining portion of the encapsulation layer 110 over the third sacrificial layer 721, is removed, exposing the rest of the third sacrificial layer 721. In some embodiments, the monolith 725 may be removed by exposure to an appropriate form of energy, for example a laser light of an appropriate wavelength, such as a UV-laser. In some embodiments, the monolith 725 may be removed using an etch process including either a wet etch or a dry etch process, for example where the material of the third sacrificial layer 721 differs from that of both the PIC 108 and the encapsulation layer 110 such that a selective etch may remove selective portions of the encapsulation layer 110 such as the monolith 725 without effecting either the PIC 108 or the third sacrificial layer 721.

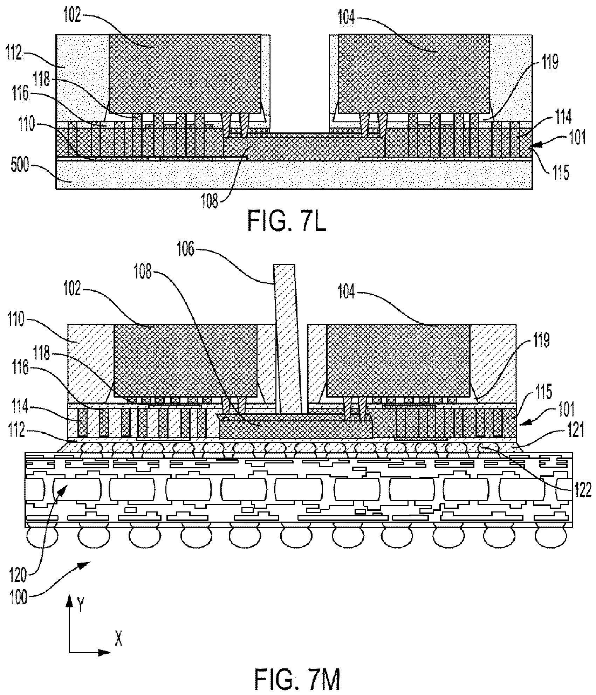

FIG. 7L depicts S890 in the process of FIG. 8 where the third sacrificial layer 721 is removed, exposing at least a portion of the PIC 108. In some embodiments, the third sacrificial layer 721 may be removed by exposure of the third sacrificial layer 721 to an appropriate form of energy, for example ultraviolet light for a photo sensitive material. In some embodiments, the third sacrificial layer 721 may be removed using an etch process including either a wet etch or a dry etch process, for example where the material of the third sacrificial layer 721 differs from that of both the PIC 108 and the encapsulation layer 110 such that a selective etch may remove the third sacrificial layer 721 without effecting either the PIC 108 or the encapsulation layer 110.

FIG. 7M depicts S895 in the process of FIG. 8 where the supportive interchange 101 is positioned on the supporting substrate 120 and connected to the first optical connection 106. The interconnection between the supportive interchange 101 on the supporting substrate 120 may include substrate interconnections 122 to couple the supportive interchange 101 to the supporting substrate 120 including pads, bumps, microbumps, pillars, balls, and other forms such as controlled-collapse chip connection C4 bumps, alone or in combination. In some embodiments, the bonding layer 121 may also include a dielectric material or an adhesive, like underfill material, to provide additional strength and connection between the supportive interchange 101 and the supporting substrate 120. In some embodiments, the interconnection may provide a metallic bonding between the supportive interchange 101 and the supporting substrate 120, a dielectric bonding between the supportive interchange 101 and the supporting substrate 120, or in some embodiments a hybrid bonding between the supportive interchange 101 and the supporting substrate 120. In some embodiments, the interconnection may bond directly with the lower RDL 112, while in other embodiments, intermediate layers may be between the interconnection and the lower RDL 112. In some embodiments, a dielectric material or adhesive material may be inserted using an underfill technique and form the bonding layer 121 on the surface of the supporting substrate 120. In some embodiments, a heat treatment or other thermal process may be provided to strengthen the bond between the supporting substrate 120 and the supportive interchange 101.

When the supportive interchange 101 is positioned on the supporting substrate 120, the first optical connection 106 may be coupled to the PIC 108. In some embodiments, the first optical connection 106 may be directly coupled to the PIC 108, while in other embodiments one or more intermediate optical components may inserted between the first optical connection 106 and the PIC 108, such as lenses, polarizers, filters, etc. In some embodiments, the first optical connection 106 may be a FAU, a pluggable optical connector, a plug connector, a v-groove, as well as combinations thereof and various arrays thereof. In some embodiments, the PIC 108 may have a corresponding coupling location to the first optical connection 106 directly on the PIC 108, while in other embodiments, an intermediate coupler may be inserted between the first optical connection 106 and the PIC 108.

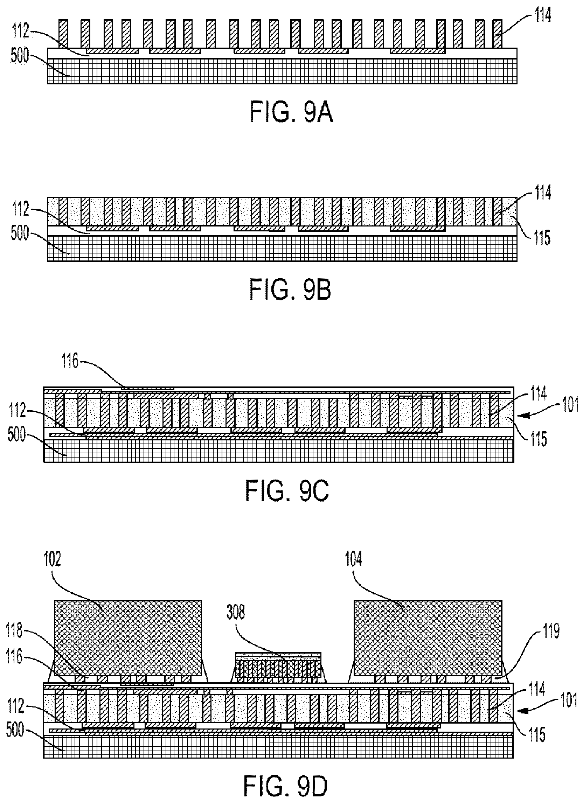

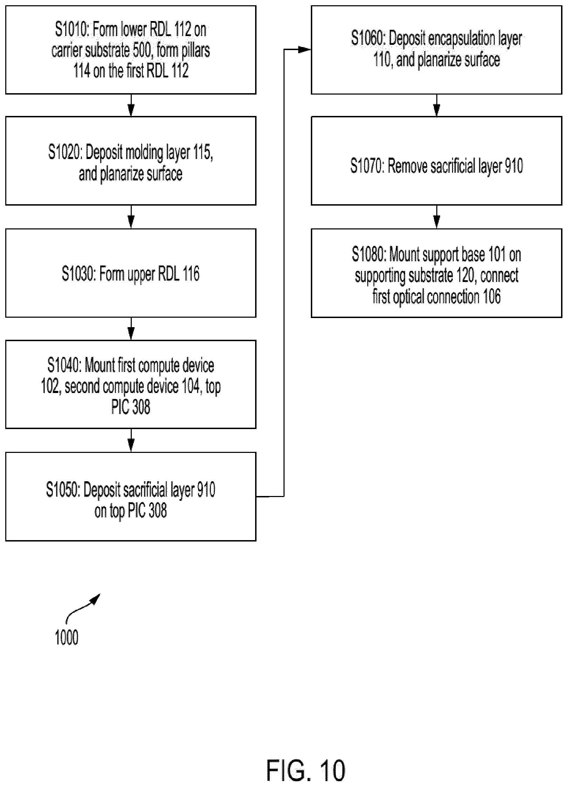

FIGS. 9A-9H depict an illustrative embodiment of a process of forming a device package architecture such as the second device package architecture 300, or any other device package architectures shown herein. FIG. 10 depicts an example embodiment of a process 1000 for forming a device package assembly corresponding to the illustrative embodiment of FIGS. 9A-9H.

FIG. 9A depicts S1010 in the process of FIG. 10 where the formation of the supportive interchange 101 begins on a carrier substrate 500 with the formation of the lower RDL 112. The carrier substrate 500 may be any suitable substrate, such as a glass substrate. In some embodiments, prior to the lower RDL 112 being formed on the carrier substrate 500, a release layer (not shown) may be formed on the carrier substrate 500. The release layer may comprise a material such as a polymer, wax, epoxy, or resin which acts as a sacrificial layer and may be cleanly removed from the carrier substrate 500 and the lower RDL 112. In some embodiments, the lower RDL 112 may be formed using complementary metal-oxide-semiconductor (CMOS) processes, such as depositing, lithography, etching, including both wet etch and dry etch, passivation directly on the carrier substrate 500. In some embodiments, the lower RDL 112 may be formed on a separate substrate and transferred to the carrier substrate 500. In addition, S610 depicts the formation of pillars 114 on the lower RDL 112. The pillars 114 may comprise a conductive material, including metals such as copper, as well as other known conductive materials, such as doped carbon. The pillars 114 are bonded to the lower RDL 112 and may form an interconnection layer for the upper RDL 116 added later. In some embodiments, the pillars 114 may be bonded using metal diffusion bonding between a metallic material forming the pillars 114 and corresponding metal materials within the lower RDL 112.

FIG. 9B depicts S1020 in the process of FIG. 10 where the molding layer 115 is deposited over the pillars 114, the lower RDL 112 and then planarized. In some embodiments, the molding layer 115 may be a dielectric such as silicon oxide or silicon nitride. After the deposition of the molding layer 115, the pillars 114, the lower RDL 112, the molding layer 115 may be subject to a process to smooth and or planarize the surface, the process including one or more grinding, polishing, and smoothing processes, including chemical mechanical polishing (CMP).

FIG. 9C depicts S1030 in the process of FIG. 10 where the upper RDL 116 is formed over the molding layer 115 and the pillars 114, also known as the embedded layers. In some embodiments, the upper RDL 116 may be formed using complementary metal-oxide-semiconductor (CMOS) processes, such as depositing, lithography, etching, passivation directly on the carrier substrate 500. In some embodiments, the upper RDL 116 may be formed on a separate substrate and transferred to the carrier substrate 500. The upper RDL 116 includes a series of pads, bumps, vias, through-vias, traces, and other forms of connection for redistributing signals from the embedded layers to an appropriate location on the top of upper RDL 116. In some embodiments, a portion of the molding layer 115 may be exposed to provide a suitable dielectric surface for forming hybrid bonds. The formation of the upper RDL 116 with the lower RDL 112, and the components between thus may be referred to as the supportive interchange 101.

FIG. 9D depicts S1040 in the process of FIG. 10 where the first compute device 102, the second compute device 104 and the top PIC 308 are positioned on the upper RDL 116. The first compute device 102, the second compute device 104 and the top PIC 308 may be positioned upon the upper RDL 116 using one or more conductive connections 118 and one or more dielectric bonds 119. The one or more conductive connections 118 may include pads, bumps, microbumps, pillars, balls, ball grids, microball arrays, and other forms such as C4 bumps, alone or in combination. The one or more dielectric bonds 119 may include a dielectric material or adhesive between the first compute device 102, the second compute device 104, or the top PIC 308 and the upper RDL 116, such as an epoxy, a resin, or other suitable material. In some embodiments, the one or more dielectric bonds 119 may be formed using an underfill technique and inserted between the first compute device 102 or the second compute device 104 and the upper RDL 116 and around the one or more conductive connections 118. In some embodiments, the one or more conductive connections 118 and the one or more dielectric bonds 119 may combine to form a hybrid bond between the first compute device 102, the second compute device 104, the top PIC 308 and the supportive interchange 101.

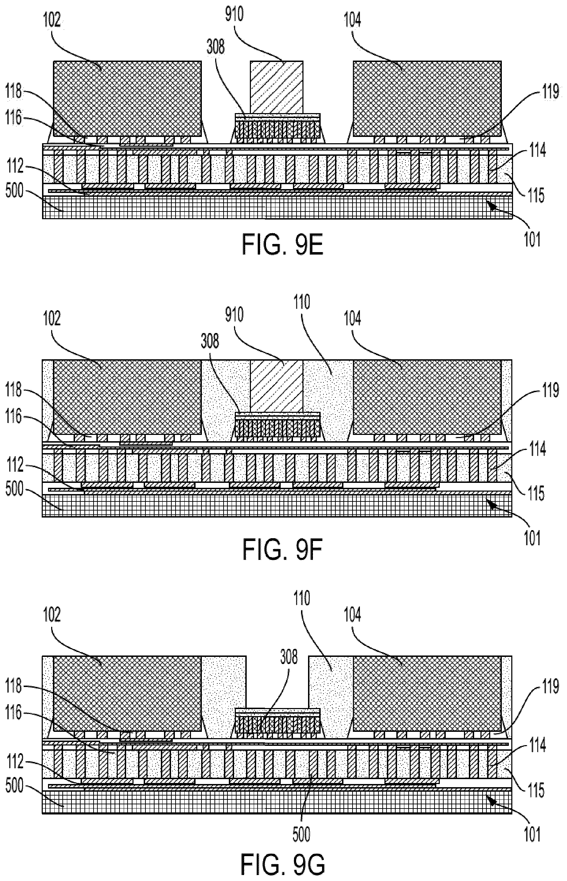

FIG. 9E depicts S1050 in the process of FIG. 10 where a fourth sacrificial layer 910 is deposited over at least a portion of the top PIC 308. The fourth sacrificial layer 910 may be formed by a material suitable for patterning, such as a photoresist material patterned by photolithography, as well as a dielectric material which may be patterned by a process such depositing the material over a mask or etch process to selectively deposit or remove the material. The fourth sacrificial layer 910 may be selectively formed over only the top PIC 308, and leave the first compute device 102, the second compute device 104 and any additional portions of the upper RDL 116 exposed.

FIG. 9F depicts S1060 in the process of FIG. 10 where the encapsulation layer 110 is deposited over the first compute device 102, the second compute device 104, the fourth sacrificial layer 910 and any additional portions of the upper RDL 116 before being then planarized. The encapsulation layer 110 may be chosen from a different material than used for the fourth sacrificial layer 910 such that a process may easily remove the material of the fourth sacrificial layer 910 while leaving the encapsulation layer 110 intact. For example, in some embodiments, the encapsulation layer 110 may be an EMC, while the fourth sacrificial layer 910 may be formed of a dielectric such as silicon carbide which may response to different etchants, while in other embodiments, the second sacrificial layer 520 may be a photoresist material. After the deposition of the encapsulation layer 110, the encapsulation layer 110 and the fourth sacrificial layer 910 may be subject to a process to smooth and or planarize the surface, the process including one or more grinding, polishing, and smoothing processes, including chemical mechanical polishing (CMP). In some embodiments, the planarization may be sufficient to expose the first compute device 102 and the second compute device 104, while in other embodiments at least one of the first compute device 102 and the second compute device 104 may be at least partially covered by a portion of the encapsulation layer 110.

FIG. 9G depicts S1070 in the process of FIG. 10 where the fourth sacrificial layer 910 is removed, exposing at least a portion of the top PIC 308. In some embodiments, the fourth sacrificial layer 910 may be removed by exposure of the fourth sacrificial layer 910 to an appropriate form of energy, for example ultraviolet light for a photo sensitive material. In some embodiments, the fourth sacrificial layer 910 may be removed using an etch process including either a wet etch or a dry etch process, for example where the material of the fourth sacrificial layer 910 differs from that of both the top PIC 308 and the encapsulation layer 110 such that a selective etch may remove the fourth sacrificial layer 910 without effecting either the top PIC 308 or the encapsulation layer 110.

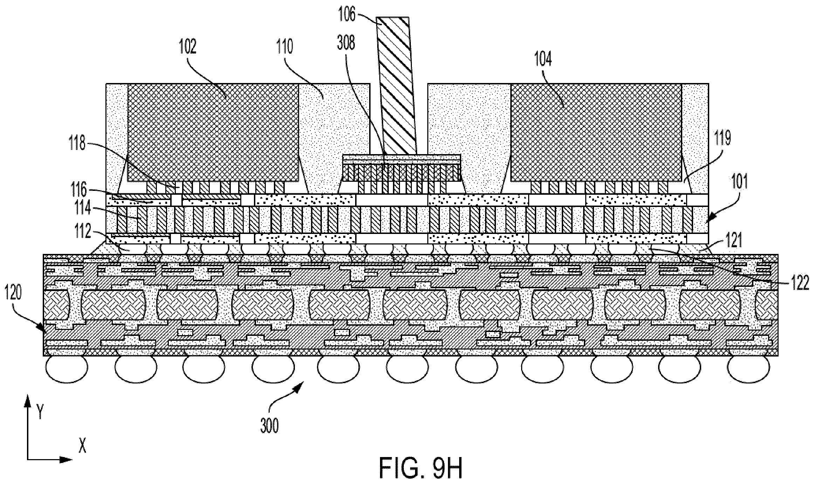

FIG. 9H depicts S1080 in the process of FIG. 10 the supportive interchange 101 is positioned on the supporting substrate 120 and connected to the first optical connection 106. The interconnection between the supportive interchange 101 on the supporting substrate 120 may include substrate interconnections 122 to couple the supportive interchange 101 to the supporting substrate 120 including pads, bumps, microbumps, pillars, balls, and other forms such as controlled-collapse chip connection C4 bumps, alone or in combination. In some embodiments, the bonding layer 121 may also include a dielectric material or an adhesive, like underfill material, to provide additional strength and connection between the supportive interchange 101 and the supporting substrate 120. In some embodiments, the interconnection may provide a metallic bonding between the supportive interchange 101 and the supporting substrate 120, a dielectric bonding between the supportive interchange 101 and the supporting substrate 120, or in some embodiments a hybrid bonding between the supportive interchange 101 and the supporting substrate 120. In some embodiments, the interconnection may bond directly with the lower RDL 112, while in other embodiments, intermediate layers may be between the interconnection and the lower RDL 112. In some embodiments, a dielectric material or adhesive material may be inserted using an underfill technique and form the bonding layer 121 on the surface of the supporting substrate 120. In some embodiments, a heat treatment or other thermal process may be provided to strengthen the bond between the supporting substrate 120 and the supportive interchange 101.

When the supportive interchange 101 is positioned on the supporting substrate 120, the first optical connection 106 may be coupled to the top PIC 308. In some embodiments, the first optical connection 106 may be directly coupled to the top PIC 308, while in other embodiments one or more intermediate optical components may inserted between the first optical connection 106 and the top PIC 308, such as lenses, polarizers, filters, etc. In some embodiments, the first optical connection 106 may be a FAU, a pluggable optical connector, a plug connector, a v-groove, as well as combinations thereof and various arrays thereof. In some embodiments, the top PIC 308 may have a corresponding coupling location to the first optical connection 106 directly on the top PIC 308, while in other embodiments, an intermediate coupler may be inserted.

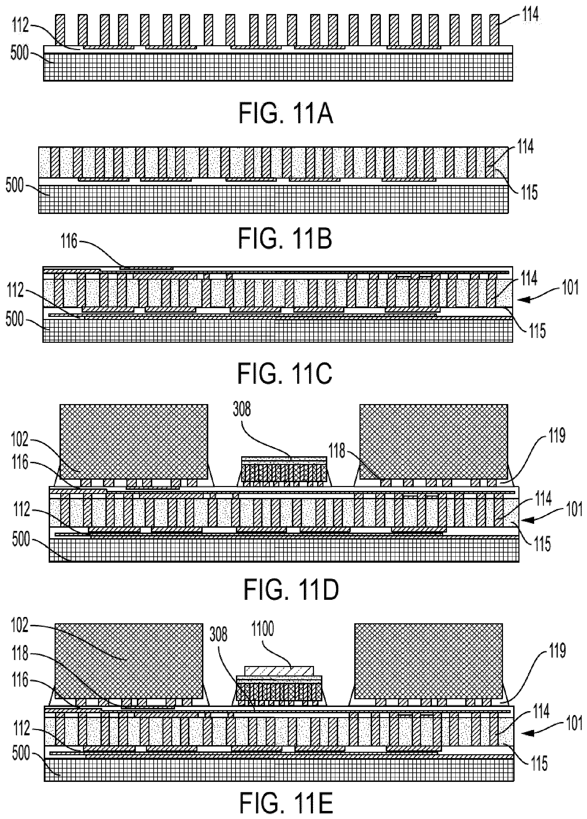

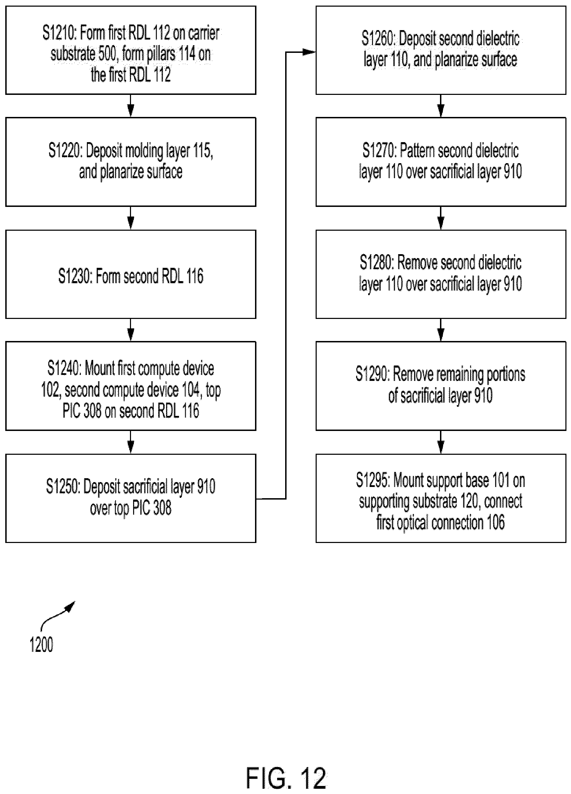

FIGS. 11A-11J depict an illustrative embodiment of a process of forming a device package architecture such as the second device package architecture 300, or any other device package architectures shown herein. FIG. 12 depicts an example embodiment of a process 1000 for forming a device package assembly corresponding to the illustrative embodiment of FIGS. 11A-11J.

FIG. 11A depicts S1210 in the process of FIG. 12 where the formation of the supportive interchange 101 begins on a carrier substrate 500 with the formation of the lower RDL 112. The carrier substrate 500 may be any suitable substrate, such as a glass substrate. In some embodiments, prior to the lower RDL 112 being formed on the carrier substrate 500, a release layer (not shown) may be formed on the carrier substrate 500. The release layer may comprise a material such as a polymer, wax, epoxy, or resin which acts as a sacrificial layer and may be cleanly removed from the carrier substrate 500 and the lower RDL 112. In some embodiments, the lower RDL 112 may be formed using complementary metal-oxide-semiconductor (CMOS) processes, such as depositing, lithography, etching, including both wet etch and dry etch, passivation directly on the carrier substrate 500. In some embodiments, the lower RDL 112 may be formed on a separate substrate and transferred to the carrier substrate 500. In addition, S610 depicts the formation of pillars 114 on the lower RDL 112. The pillars 114 may comprise a conductive material, including metals such as copper, as well as other known conductive materials, such as doped carbon. The pillars 114 are bonded to the lower RDL 112 and may form an interconnection layer for the upper RDL 116 added later. In some embodiments, the pillars 114 may be bonded using metal diffusion bonding between a metallic material forming the pillars 114 and corresponding metal materials within the lower RDL 112.

FIG. 11B depicts S1220 in the process of FIG. 12 where the molding layer 115 is deposited over the pillars 114, the lower RDL 112 and then planarized. In some embodiments, the molding layer 115 may be a dielectric such as silicon oxide or silicon nitride. After the deposition of the molding layer 115, the pillars 114, the lower RDL 112, the molding layer 115 may be subject to a process to smooth and or planarize the surface, the process including one or more grinding, polishing, and smoothing processes, including chemical mechanical polishing (CMP).

FIG. 11C depicts S1230 in the process of FIG. 12 where the upper RDL 116 is formed over the molding layer 115 and the pillars 114, also known as the embedded layers. In some embodiments, the upper RDL 116 may be formed using complementary metal-oxide-semiconductor (CMOS) processes, such as depositing, lithography, etching, passivation directly on the carrier substrate 500. In some embodiments, the upper RDL 116 may be formed on a separate substrate and transferred to the carrier substrate 500. The upper RDL 116 includes a series of pads, bumps, vias, through-vias, traces, and other forms of connection for redistributing signals from the embedded layers to an appropriate location on the top of upper RDL 116. In some embodiments, a portion of the molding layer 115 may be exposed to provide a suitable dielectric surface for forming hybrid bonds. The formation of the upper RDL 116 with the lower RDL 112, and the components between thus may be referred to as the supportive interchange 101.

FIG. 11D depicts S1240 in the process of FIG. 12 where the first compute device 102, the second compute device 104 and the top PIC 308 are positioned on the upper RDL 116. The first compute device 102, the second compute device 104 and the top PIC 308 may be positioned upon the upper RDL 116 using one or more conductive connections 118 and one or more dielectric bonds 119. The one or more conductive connections 118 may include pads, bumps, microbumps, pillars, balls, ball grids, microball arrays, and other forms such as C4 bumps, alone or in combination. The one or more dielectric bonds 119 may include a dielectric material or adhesive between the first compute device 102, the second compute device 104, or the top PIC 308 and the upper RDL 116, such as an epoxy, a resin, or other suitable material. In some embodiments, the one or more dielectric bonds 119 may be formed using an underfill technique and inserted between the first compute device 102 or the second compute device 104 and the upper RDL 116 and around the one or more conductive connections 118. In some embodiments, the one or more conductive connections 118 and the one or more dielectric bonds 119 may combine to form a hybrid bond between the first compute device 102, the second compute device 104, the top PIC 308 and the supportive interchange 101.

FIG. 11E depicts S1250 in the process of FIG. 12 where a fifth sacrificial layer 1100 is deposited over at least a portion of the top PIC 308. The fifth sacrificial layer 1100 may be formed by a material suitable for patterning, such as a photoresist material patterned by photolithography, as well as a dielectric material which may be patterned by a process such depositing the material over a mask or etch process to selectively deposit or remove the material. The fifth sacrificial layer 1100 may be selectively formed over only the top PIC 308, and leave the first compute device 102, the second compute device 104 and any additional portions of the upper RDL 116 exposed. The fifth sacrificial layer 1100, unlike the fourth sacrificial layer 910, may be formed such as to cover a portion of the top PIC 308, instead of filling the space between the first compute device 102 and the second compute device 104. In some embodiments, the fifth sacrificial layer 1100 may be formed of the same material as the fourth sacrificial layer 910, while in other embodiments, the materials may differ.

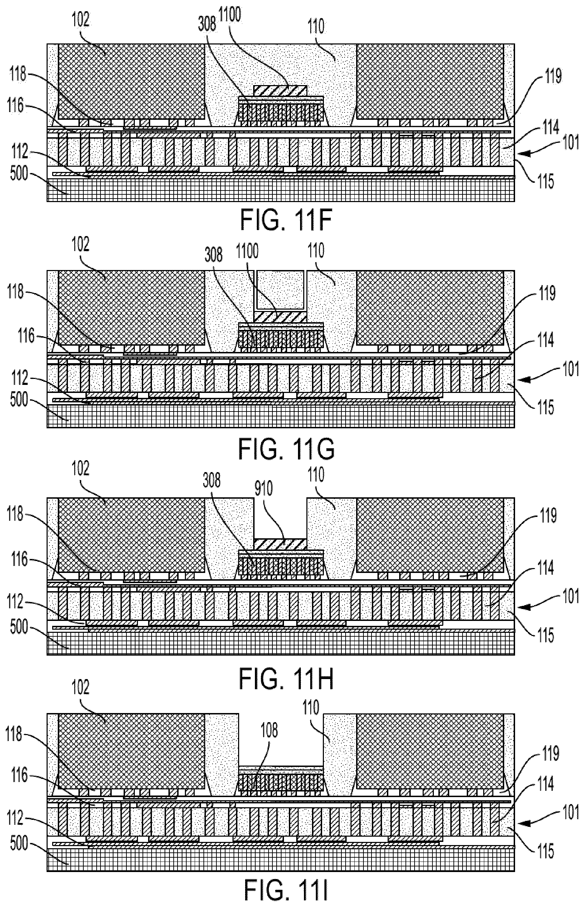

FIG. 11F depicts S1260 in the process of FIG. 12 where the encapsulation layer 110 is deposited over the first compute device 102, the second compute device 104, the fifth sacrificial layer 1100 and any additional portions of the upper RDL 116 before being then planarized. The encapsulation layer 110 may be chosen from a different material than used for the fifth sacrificial layer 1100 such that a process may easily remove the material of the fifth sacrificial layer 1100 while leaving the encapsulation layer 110 intact. For example, in some embodiments, the encapsulation layer 110 may be an EMC, while the fifth sacrificial layer 1100 may be formed of a dielectric such as silicon carbide which may response to different etchants, while in other embodiments, the fifth sacrificial layer 1100 may be a photoresist material. After the deposition of the encapsulation layer 110, the encapsulation layer 110 and the fifth sacrificial layer 1100 may be subject to a process to smooth and or planarize the surface, the process including one or more grinding, polishing, and smoothing processes, including chemical mechanical polishing (CMP). In some embodiments, the planarization may be sufficient to expose the first compute device 102 and the second compute device 104, while in other embodiments at least one of the first compute device 102 and the second compute device 104 may be at least partially covered by a portion of the encapsulation layer 110.

FIG. 11G depicts S1270 in the process of FIG. 12 where the portion of the encapsulation layer 110 over the fifth sacrificial layer 1100 is removed, exposing at least a portion of the fifth sacrificial layer 1100. In some embodiments, the portion of the encapsulation layer 110 over the fifth sacrificial layer 1100 may be removed by exposure to an appropriate form of energy, for example a laser light of an appropriate wavelength, such as a UV-laser. In some embodiments, encapsulation layer 110 may be removed using an etch process including either a wet etch or a dry etch process, for example where the material of the fifth sacrificial layer 1100 differs from that of both the top PIC 308 and the encapsulation layer 110 such that a selective etch may remove the encapsulation layer 110 without effecting either the top PIC 308 or the fifth sacrificial layer 1100.

FIG. 11H depicts S1280 in the process of FIG. 12 where the remaining portion of the encapsulation layer 110 over the fifth sacrificial layer 1100 is removed, exposing the rest of the fifth sacrificial layer 1100. In some embodiments, the remaining portion of the encapsulation layer 110 over the fifth sacrificial layer 1100 may be removed by exposure to an appropriate form of energy, for example a laser light of an appropriate wavelength, such as a UV-laser. In some embodiments, the remaining portion of the encapsulation layer 110 may be removed using an etch process including either a wet etch or a dry etch process, for example where the material of the fifth sacrificial layer 1100 differs from that of both the top PIC 308 and the encapsulation layer 110 such that a selective etch may remove the encapsulation layer 110 without effecting either the top PIC 308 or the fifth sacrificial layer 1100.

FIG. 11I depicts S1290 in the process of FIG. 12 where the fifth sacrificial layer 1100 is removed, exposing at least a portion of the top PIC 308. In some embodiments, the fifth sacrificial layer 1100 may be removed by exposure of the third sacrificial layer 721 to an appropriate form of energy, for example ultraviolet light for a photo sensitive material. In some embodiments, the fifth sacrificial layer 1100 may be removed using an etch process including either a wet etch or a dry etch process, for example where the material of the fifth sacrificial layer 1100 differs from that of both the top PIC 308 and the encapsulation layer 110 such that a selective etch may remove the fifth sacrificial layer 1100 without effecting either the top PIC 308 or the encapsulation layer 110.

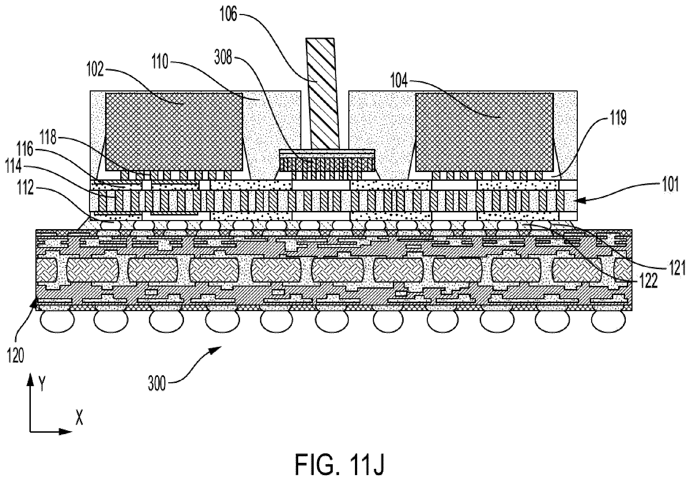

FIG. 11J depicts S1295 in the process of FIG. 12 where the supportive interchange 101 is positioned on the supporting substrate 120 and connected to the first optical connection 106. The interconnection between the supportive interchange 101 on the supporting substrate 120 may include substrate interconnections 122 to couple the supportive interchange 101 to the supporting substrate 120 including pads, bumps, microbumps, pillars, balls, and other forms such as controlled-collapse chip connection C4 bumps, alone or in combination. In some embodiments, the bonding layer 121 may also include a dielectric material or an adhesive, like underfill material, to provide additional strength and connection between the supportive interchange 101 and the supporting substrate 120. In some embodiments, the interconnection may provide a metallic bonding between the supportive interchange 101 and the supporting substrate 120, a dielectric bonding between the supportive interchange 101 and the supporting substrate 120, or in some embodiments a hybrid bonding between the supportive interchange 101 and the supporting substrate 120. In some embodiments, the interconnection may bond directly with the lower RDL 112, while in other embodiments, intermediate layers may be between the interconnection and the lower RDL 112. In some embodiments, a dielectric material or adhesive material may be inserted using an underfill technique and form the bonding layer 121 on the surface of the supporting substrate 120. In some embodiments, a heat treatment or other thermal process may be provided to strengthen the bond between the supporting substrate 120 and the supportive interchange 101.

When the supportive interchange 101 is positioned on the supporting substrate 120, the first optical connection 106 may be coupled to the top PIC 308. In some embodiments, the first optical connection 106 may be directly coupled to the top PIC 308, while in other embodiments one or more intermediate optical components may inserted between the first optical connection 106 and the top PIC 308, such as lenses, polarizers, filters, etc. In some embodiments, the first optical connection 106 may be a FAU, a pluggable optical connector, a plug connector, a v-groove, as well as combinations thereof and various arrays thereof. In some embodiments, the top PIC 308 may have a corresponding coupling location to the first optical connection 106 directly on the top PIC 308, while in other embodiments, an intermediate coupler may be inserted.

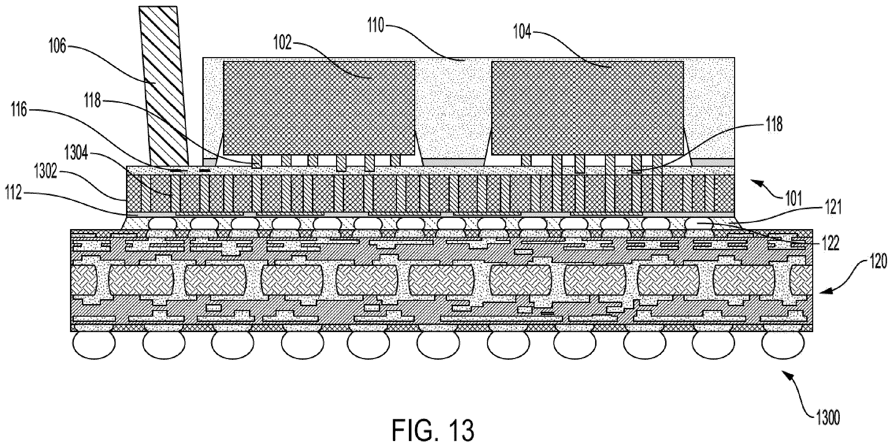

FIG. 13 depicts an exemplary embodiment of a third device package architecture 1300 where the supportive interchange 101 is formed around an interposer 1302 opposed to the PIC 108. The interposer 1302 may be an additional substrate, die, chip, or other circuit device and may incorporate an EIC, a PIC, or combination thereof. The supportive interchange 101 may be formed similar to as described with respect to the example embodiment of FIG. 1, but with interposer 1302 extending across the width of the supportive interchange 101 rather than the PIC 108 extending across only a portion of the supportive interchange 101. Additionally, as the interposer 1302 may replace the PIC 108, the first optical connection 106 may be relocated from the center of the supportive interchange 101 to an edge of the supportive interchange 101 when the interposer 1302 includes optical components. In some embodiments, where the interposer 1302 lacks optical components, the first optical connection 106 may be omitted. Furthermore, the interposer 1302 may have the upper RDL 116 and the lower RDL 112 formed directly on the interposer 1302. As such, rather than pillars 114 connecting the upper RDL 116 and the lower RDL 112, one or more vias 1304 may be formed within the interposer 1302 to provide a connection between the upper RDL 116 and the lower RDL 112.

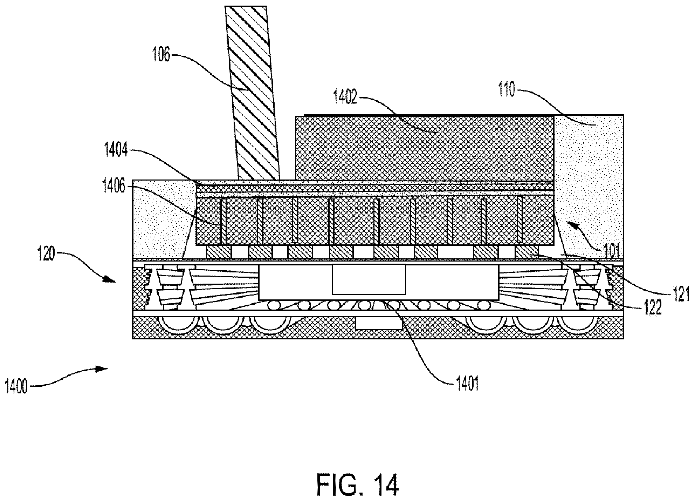

FIG. 14 depicts an exemplary embodiment of a fourth device package architecture 1400 where a logic chip 1401 may be embedded within the supporting substrate 120 and the PIC 108 positioned directly upon the supporting substrate 120 without a supportive interchange 101. The fourth device package architecture 1400 may further differentiate from the other device package architectures by including a dummy layer 1402 on top of the PIC 108, with the dummy layer 1402 being formed of a thermally conductive material, such as silicon, able to provide a thermal pathway and potentially dissipating heat. Similar to the top PIC 308 of the third device package architecture 1300, one or more vias 1406 may be formed within the PIC 108 to route electrical signals within the PIC 108. The signals may travel from the supporting substrate 120 to an active layer 1404 on the PIC 108. The active layer 1404 may include various optical components, such as couplers, splitters, etc., with the one or more vias 1406 allowing electrical signals to reach components such as heaters providing control of the optical components of the active layer 1404. The first optical connection 106 may connect directly to the PIC 108, with the dummy layer 1402 shaped to allow a direct connection to the PIC 108. The encapsulation layer 110 may be trimmed back around the first optical connection 106 to allow access to the PIC 108.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A system comprising:
a substrate having a first side and a second side opposite the first side;
a first compute device positioned on the first side of the substrate;
a second compute device positioned on the first side of the substrate;
a photonic integrated circuit arranged between the first compute device and the second compute device, the photonic integrated circuit communicatively coupled to the first compute device and the second compute device; and
an optical fiber connection extending between the first compute device and the second compute device.

2. The system of claim 1, comprising a supportive interchange on the substrate, wherein:
the first compute device is positioned on the supportive interchange;
the second compute device is positioned on the supportive interchange; and
the optical fiber connection is coupled to the photonic integrated circuit.

3. The system of claim 2, wherein the first compute device includes at least one selected from a group consisting of a memory device and a processing device.

4. The system of claim 2 or 3, further comprising a redistribution layer arranged between the photonic integrated circuit and the first compute device and arranged between the photonic integrated circuit and the second compute device, the redistribution layer communicatively coupling the photonic integrated circuit and the first compute device, and the redistribution layer communicatively coupling the photonic integrated circuit and the second compute device.

5. The system of any one of claims 2 to 4, wherein the photonic integrated circuit is at least partially embedded within the supportive interchange.

6. The system of any one of claims 2 to 5, wherein the photonic integrated circuit is positioned on the supportive interchange.

7. The system of any one of claims 2 to 6, wherein
the photonic integrated circuit comprises a first photonic integrated circuit and a second photonic integrated circuit, and
the optical fiber connection comprises a first optical fiber connection coupled to the first photonic integrated circuit and a second optical fiber connection coupled to the second photonic integrated circuit.

8. The system of any one of claims 2 to 7, wherein
the supportive interchange has a first side and a second side opposite the first side,
the first compute device is positioned on the first side of the supportive interchange,
the second compute device is positioned on the first side of the supportive interchange, and
the photonic integrated circuit is positioned on the first side of the supportive interchange.

9. The system of any one of claims 2 to 8, further comprising an encapsulation layer,
wherein the encapsulation layer extends between the first compute device, the second compute device and the optical fiber connection.

10. The system of claim 1, wherein the photonic integrated circuit is at least partially embedded within the substrate.

11. The system of any one of claims 1 to 10, wherein the photonic integrated circuit is positioned on the first side of the substrate and the first compute device is positioned at least partially over the photonic integrated circuit.

12. The system of any one of claims 1 to 11, wherein
the first compute device includes at least one selected from the group consisting of a memory device and a processing device, and
the second compute device includes at least one selected from the group consisting of a memory device and a processing device.

13. The system of any one of claims 1 to 12, wherein the first compute device and the second compute device differ in device composition.

14. The system of any one of claims 1 to 12, wherein the first compute device and the second compute device have the same device composition.

15. The system of any one of claims 1 to 14, further comprising a redistribution layer arranged between the photonic integrated circuit and the first compute device and arranged between the photonic integrated circuit and the second compute device, the redistribution layer communicatively coupling the photonic integrated circuit and the first compute device, and the redistribution layer communicatively coupling the photonic integrated circuit and the second compute device.
